# EUROPEAN PATENT APPLICATION

(11) **EP 4 318 585 A1**
(43) Date of publication of application: **07.02.2024**
(21) Application number: 21932195.7
(22) Date of filing: 25.03.2021
(51) Int. Cl.: H01L 27/092, H01L 21/8238

(54) **INVERTER AND PREPARATION METHOD THEREFOR, SEMICONDUCTOR DEVICE, CHIP, AND TERMINAL DEVICE**

(71) Applicant: Huawei Technologies Co., Ltd., Longgang Shenzhen, Guangdong 518129 (CN)
(72) Inventor: WAN, Guangxing, Shenzhen, Guangdong 518129 (CN); YIN, Xiaogen, Shenzhen, Guangdong 518129 (CN); WONG, Waisum, Shenzhen, Guangdong 518129 (CN)
(74) Representative: Huawei European IPR
(86) International application number: PCT/CN2021/083007
(87) International publication number: WO 2022/198568

(57) **Abstract**

This application provides an inverter and a preparation method thereof, a semiconductor device, a chip, and a terminal device. The inverter includes a substrate, and an n-type field effect transistor and a p-type field effect transistor that are stacked on the substrate, where the n-type field effect transistor includes a second gate and a second channel, and the p-type field effect transistor includes a first gate and a first channel. Each of the first channel and the second channel includes a crystal plane (110) perpendicular to a top surface of the substrate and a crystal plane (100) parallel to the top surface of the substrate. A size of the first channel in a first direction is larger than that in a second direction, a size of the second channel in the first direction is smaller than that in the second direction, and the size of the first channel in the first direction is larger than the size of the second channel in the first direction. The first gate covers at least one of a first surface and a second surface, and the second gate covers at least one of a third surface and a fourth surface. This solution of this application can improve electron hole mobility in the p-type field effect transistor, improve electrical performance, and further improve miniaturization performance of the inverter.

## Description

### TECHNICAL FIELD

This application relates to the field of semiconductor technologies, and in particular, to an inverter and a preparation method thereof, a semiconductor device, a chip, and a terminal device.

### BACKGROUND

A current inverter is composed of a pair of N-type MOS transistor and P-type MOS transistor to constitute a complementary metal-oxide-semiconductor (Complementary Metal-Oxide-Semiconductor, CMOS). An integrated circuit in which a basic circuit unit composed of the inverter realizes a specific logic function is referred to as a CMOS circuit. In a process of scaling down a MOS device, a FinFET (Fin Field Effect Transistor, FinFET) extends Moore's Law because of excellent performance and compatibility with a traditional CMOS process. With continuous indentation of a MOSFET device, miniaturization performance of the FinFET gradually reaches a limit. A CFET structure with a channel as a nano-sheet emerges in the industry, and an N-type channel of the N-type MOS transistor and a P-type channel of the P-type MOS transistor are made into nano-sheets that are parallel to a substrate and that are stacked vertically. Therefore, a P-type channel crystal plane of the P-type MOS transistor changes from a crystal plane (110) to a crystal plane (100). Although there is a specific miniaturization property, electron hole mobility is greatly reduced, and performance of the P-type MOS transistor is seriously degraded.

### SUMMARY

Based on an existing CFET structure, this application provides an inverter for improving electron hole mobility and miniaturization performance of a p-type field effect transistor.

According to a first aspect, this application provides an inverter, where the inverter includes a substrate, and an n-type field effect transistor and a p-type field effect transistor that are located on a top surface of the substrate and that are stacked along a first direction, where the p-type field effect transistor includes a first gate and a first channel, and the n-type field effect transistor includes a second gate and a second channel.

Each of the first channel and the second channel includes a crystal plane (110) perpendicular to the top surface of the substrate and a crystal plane (100) parallel to the top surface of the substrate, where a size of the first channel in the first direction is larger than that in a second direction, a size of the second channel in the first direction is smaller than that in the second direction, and the size of the first channel in the first direction is larger than the size of the second channel in the first direction, where the first direction is perpendicular to the top surface of the substrate, and the second direction is parallel to the top surface of the substrate.

The first channel includes a first surface and a second surface that are disposed oppositely and that both include the crystal plane (110), where the first surface and the second surface are arranged along the second direction, and the first gate covers at least one of the first surface and the second surface; and the second channel includes a third surface and a fourth surface that are disposed oppositely and that both include the crystal plane (100), where the third surface and the fourth surface are arranged along the first direction, and the second gate covers at least one of the third surface and the fourth surface.

The size of the first channel in the first direction is a longest distance between two ends of the first channel in the first direction, and the size of the first channel in the second direction is a longest distance between two ends of the first channel in the second direction. The size of the second channel in the first direction is a longest distance between two ends of the second channel in the first direction, and the size of the second channel in the second direction is a longest distance between two ends of the second channel in the second direction.

The top surface of the substrate is a surface close to the first channel and the second channel.

Materials of the first channel and the second channel are single crystal semiconductors, including at least one of SI, Ge, SiGe, GaAs, InSb, GaP, GaSb, InAlAs, InGaAs, GaSbP, GaAsSb, and InP. Selection and proportioning of these materials are not limited in this application, provided that the first channel includes the crystal plane (110) that is conducive to electron hole transmission and that is perpendicular to the top surface of a substrate 100, and that the second channel includes the crystal plane (100) that is conducive to electron transmission and that is parallel to the top surface of the substrate. In this application, the first channel of the p-type field effect transistor is a p-type channel, or the first channel is p-type doped, and current carriers of the p-type channel are electron holes. The size of the first channel in the first direction is set to be larger than that in the second direction. In other words, an area of the first surface and the second surface that both include the crystal plane (110) are larger than an area of surfaces of the first channel that are disposed oppositely in the second direction, so that electron hole mobility of the p-type field effect transistor is high, and performance of the p-type field effect transistor can be improved. The second channel of the n-type field effect transistor is an n-type channel, or the second channel is n-type doped, and current carriers of the n-type channel are electrons. The size of the second channel in the first direction is set to be smaller than that in the second direction. In other words, an area of the third surface and the fourth surface that both include the crystal plane (100) are larger than an area of surfaces of the second channel that are disposed oppositely in the first direction, so that electron mobility of the n-type field effect transistor is high, and performance of the n-type field effect transistor can be improved.

In comparison with an inverter in which the p-type channel is disposed parallel to the top surface of the substrate, the inverter provided in this application can improve electron hole mobility in the first channel of the p-type field effect transistor, and improve electrical performance of the inverter. In comparison with an inverter in which both the p-type channel and the n-type channel are stacked perpendicular to the substrate, the inverter in this application disposes the second channel parallel to the top surface of the substrate, so that the size of the second channel in the first direction is smaller, and miniaturization performance of the inverter can be improved.

In an implementation, the first gate covers the first surface, and the second gate covers the third surface, where the third surface is disposed farther away from the substrate than the fourth surface. The first surface and the second surface are perpendicular to the top surface of the substrate, and the third surface and the fourth surface are parallel to the top surface of the substrate.

In a possible implementation, the first channel further includes a fifth surface and a sixth surface that are disposed oppositely, the fifth surface and the sixth surface are arranged along the first direction, the first surface, the fifth surface, the second surface, and the sixth surface are sequentially connected, and the first gate further covers at least one of the fifth surface and the sixth surface.

In a possible implementation, the fifth surface and the sixth surface are parallel to the top surface of the substrate.

In a possible implementation, the first surface and the second surface separately intersect with the top surface of the substrate, and both the fifth surface and the sixth surface are parallel to the top surface of the substrate. A section plane of the first channel is a trapezoid, the section plane of the first channel is a section plane obtained by cutting the first channel by a line perpendicular to the first channel, and the section plane of the first channel is in a shape that is narrower in the top and wider in the bottom. In other words, a size of an end of the first channel close to the substrate is the largest. Therefore, the size of the first channel in the second direction is the size of the end of the first channel close to the substrate. The size of the first channel in the first direction is a distance between the fifth surface and the sixth surface.

In a possible implementation, the first gate covers the first surface and the fifth surface.

In an implementation, an intersection position between the first surface and the fifth surface is an arc-shaped transition. In an implementation, an intersection position between the second surface and the fifth surface is an arc-shaped transition.

In an implementation, the first gate covers the first surface, the second surface, and the fifth surface. The first channel is a three-sided gate structure.

In an implementation, the first gate covers the first surface, the second surface, the fifth surface, and the sixth surface. The first channel is a four-sided gate structure.

In a possible implementation, the second channel further includes a seventh surface and an eighth surface that are disposed oppositely, the seventh surface and the eighth surface are arranged along the second direction, the third surface, the eighth surface, the fourth surface, and the seventh surface are sequentially connected, and the second gate further covers at least one of the seventh surface and the eighth surface.

In a possible implementation, the seventh surface and the eighth surface are perpendicular to the top surface of the substrate.

In an implementation, the second gate covers the third surface and the seventh surface.

In an implementation, an intersection position between the third surface and the seventh surface is an arc-shaped transition. In an implementation, an intersection position between the fourth surface and the seventh surface is an arc-shaped transition.

In an implementation, the second gate further covers the third surface, the seventh surface, and the eighth surface. The second channel is a three-sided gate structure.

In an implementation, the second gate covers the third surface, the fourth surface, the seventh surface, and the eighth surface. The second channel is a four-sided gate structure.

In an implementation, the section plane of the first channel is a trapezoid and a section plane of the second channel is a rectangle.

In a possible implementation, the n-type field effect transistor is located on a side of the substrate, and the p-type field effect transistor is located on a side that is of the n-type field effect transistor and that is away from the substrate.

In a possible implementation, the p-type field effect transistor is located on a side of the substrate, and the n-type field effect transistor is located on a side that is of the p-type field effect transistor and that is away from the substrate.

In a possible implementation, there are at least two first channels, and the at least two first channels are arranged and disposed at intervals along the second direction; and there are at least two second channels, and the at least two second channels are arranged and disposed at intervals along the first direction.

In an implementation, at least a part of orthographic projections of the first channel and the second channel on the substrate do not overlap. In other words, a central axis of the first channel and a central axis of the second channel may not overlap, and the two may be disposed in a misplaced manner, so that a process difficulty is reduced.

In an implementation, a quantity of first channels is the same as a quantity of second channels. Specifically, there are three first channels and three second channels, and the three first channels and the three second channels are all four-sided gate structures.

In a possible implementation, the p-type field effect transistor further includes a first source and a first drain, and the n-type field effect transistor further includes a second source and a second drain, where the first source and the first drain are located at two ends of the first channel along a third direction and are electrically connected to the first channel, the second source and the second drain are located at two ends of the second channel along the third direction and are electrically connected to the second channel, the first source and the second drain are disposed on a same side, the first drain and the second source are disposed on a same side, and the third direction intersects the first direction and the second direction separately.

In a possible implementation, the inverter further includes an input end, an output end, a first voltage end, and a second voltage end, where the first gate and the second gate are electrically connected to the input end, the first source and the second drain are electrically connected to the output end, the first drain is electrically connected to the first voltage end, and the second source is electrically connected to the second voltage end.

In a possible implementation, a first epitaxial structure is disposed on a peripheral side of the second source, a first interlayer dielectric layer is disposed between the first epitaxial structure and the second voltage end, a first through hole is disposed in the first interlayer dielectric layer, and the first epitaxial structure is electrically connected to the second voltage end through the first through hole, so that the second source is electrically connected to the second voltage end.

A second epitaxial structure is disposed on a peripheral side of the second drain, a third epitaxial structure is disposed on a peripheral side of the first source, a third interlayer dielectric layer is disposed between the first source and the third epitaxial structure and between the second drain and the second epitaxial structure, a third through hole is disposed in the third interlayer dielectric layer, and the third epitaxial structure is electrically connected to the second epitaxial structure through the third through hole, so that the first source is electrically connected to the second drain.

In a possible implementation, a fourth epitaxial structure is disposed on a peripheral side of the first drain, a second interlayer dielectric layer is disposed between the fourth epitaxial structure and the first voltage end, a second through hole is disposed in the second interlayer dielectric layer, and the fourth epitaxial structure is electrically connected to the first voltage end through the second through hole, so that the first drain is electrically connected to the first voltage end.

In a possible implementation, the output end is located on a side that is of the first source and that is away from the second drain, a fifth interlayer dielectric layer is disposed between the first source and the output end, a fourth through hole is disposed in the fifth interlayer dielectric layer, and the first source is electrically connected to the output end through the fourth through hole.

The input end is located on a side that is of the first gate and that is away from the second gate, a sixth interlayer dielectric layer is disposed between the first gate and the input end, a fifth through hole is disposed in the sixth interlayer dielectric layer, and the first gate is electrically connected to the input end through the fifth through hole.

In a possible implementation, the first gate and the second gate are of an integrated structure.

According to a second aspect, this application further provides a semiconductor device, including a substrate and a ridged gate erected on a top surface of the substrate, where the semiconductor device further includes a plurality of first fins passing through the gate and a plurality of second fins passing through the gate.

The plurality of first fins are parallel to each other, and the first fins are perpendicular to the top surface of the substrate, where a partial structure that is of the first fins and that is surrounded by the gate is p-type doped.

The plurality of second fins are parallel to each other, and the second fins are parallel to the top surface of the substrate, where a partial structure that is of the second fins and that is surrounded by the gate is n-type doped.

In a possible implementation, the plurality of first fins pass through a first region of the gate, the plurality of second fins pass through a second region of the gate, and the first region and the second region are isolated from each other.

In a possible implementation, the semiconductor device further includes a second insulation layer formed in the gate, and the second insulation layer is located between the first fin and the second fin.

In a possible implementation, each of the first fin and the second fin includes a crystal plane (110) perpendicular to the top surface of the substrate and a crystal plane (100) parallel to the top surface of the substrate; and a size of the first fin in a first direction is larger than that in a second direction, a size of the second fin in the first direction is smaller than that in the second direction, and the size of the first fin in the first direction is larger than the size of the second fin in the first direction, where the first direction is perpendicular to the top surface of the substrate, and the second direction is parallel to the top surface of the substrate.

The first fin includes a first surface and a second surface that are disposed oppositely and that both include the crystal plane (110), where the first surface and the second surface are arranged along the second direction; and the second fin includes a third surface and a fourth surface that are disposed oppositely and that both include the crystal plane (100), where the third surface and the fourth surface are arranged along the first direction.

In a possible implementation, the second fin is located on a side of the substrate, and the first fin is located on a side that is of the second fin and that is away from the substrate.

In a possible implementation, the first fin is located on a side of the substrate, and the second fin is located on a side that is of the first fin and that is away from the substrate.

In a possible implementation, the semiconductor device further includes a first source, a first drain, a second source, and a second drain, where the first source and the first drain are located at two ends of the first fin along a third direction and are electrically connected to the first fin, the second source and the second drain are located at two ends of the second fin along the third direction and are electrically connected to the second fin, the first source and the second drain are disposed on a same side, the first drain and the second source are disposed on a same side, and the third direction intersects the first direction and the second direction separately.

In a possible implementation, the semiconductor device further includes an input end, an output end, a first voltage end, and a second voltage end, where a first gate and a second gate are electrically connected to the input end, the first source and the second drain are electrically connected to the output end, the first drain is electrically connected to the first voltage end, and the second source is electrically connected to the second voltage end.

In a possible implementation, a first epitaxial structure is disposed on a peripheral side of the second source, a first interlayer dielectric layer is disposed between the first epitaxial structure and the second voltage end, a first through hole is disposed in the first interlayer dielectric layer, and the first epitaxial structure is electrically connected to the second voltage end through the first through hole, so that the second source is electrically connected to the second voltage end.

A second epitaxial structure is disposed on a peripheral side of the second drain, a third epitaxial structure is disposed on a peripheral side of the first source, a third interlayer dielectric layer is disposed between the third epitaxial structure and the second epitaxial structure, a third through hole is disposed in the third interlayer dielectric layer, and the third epitaxial structure is electrically connected to the second epitaxial structure through the third through hole, so that the first source is electrically connected to the second drain.

In a possible implementation, a fourth epitaxial structure is disposed on a peripheral side of the first drain, a second interlayer dielectric layer is disposed between the fourth epitaxial structure and the first voltage end, a second through hole is disposed in the second interlayer dielectric layer, and the fourth epitaxial structure is electrically connected to the first voltage end through the second through hole, so that the first drain is electrically connected to the first voltage end.

In a possible implementation, the output end is located on a side that is of the first source and that is away from the second drain, a fifth interlayer dielectric layer is disposed between the first source and the output end, a fourth through hole is disposed in the fifth interlayer dielectric layer, and the first source is electrically connected to the output end through the fourth through hole.

The input end is located on a side that is of the first gate and that is away from the second gate, a sixth interlayer dielectric layer is disposed between the first gate and the input end, a fifth through hole is disposed in the sixth interlayer dielectric layer, and the first gate is electrically connected to the input end through the fifth through hole.

According to a third aspect, this application provides a chip, where the chip includes the inverter according to any one of the foregoing implementations or the semiconductor device according to any one of the foregoing implementations. The semiconductor device further includes a base board, and the inverter or the semiconductor device is disposed in the base board. The semiconductor device further includes a connecting line and an electronic component, and the inverter or the semiconductor device is electrically connected to the electronic component through the connecting line. Using the inverter or the semiconductor device that can improve both electrical performance and miniaturization performance in this application can also improve electrical performance and miniaturization performance of the chip.

According to a fourth aspect, this application provides a terminal device, where the terminal device includes the inverter according to any one of the foregoing implementations or the semiconductor device according to any one of the foregoing implementations. The terminal device includes a circuit board, and the inverter or the semiconductor device is disposed in the circuit board. The terminal device includes but is not limited to a communication device, a home appliance, a computer, an unmanned aerial vehicle, and the like. For example, the terminal device is a mobile phone, and the mobile phone includes a display screen, a circuit board, a middle frame, and a rear cover, where the display screen and the rear cover are enclosed to form accommodation space, and the circuit board and the middle frame are located in the accommodation space. Using the inverter or the semiconductor device that can improve both electrical performance and miniaturization performance in this application can reduce a space size of the circuit board while ensuring electrical performance of the circuit board, and can further reduce a space size of the terminal device.

According to a fifth aspect, this application provides an inverter preparation method, where the inverter preparation method includes:
forming a first channel and a second channel on a substrate, exposing a first surface and a second surface of the first channel that are disposed oppositely and that both include a crystal plane (110), where the first surface and the second surface are arranged along a second direction; and exposing a third surface and a fourth surface of the second channel that are disposed oppositely and that both include a crystal plane (100), where the third surface and the fourth surface are arranged along a first direction, each of the first channel and the second channel includes the crystal plane (110) perpendicular to a top surface of the substrate and the crystal plane (100) parallel to the top surface of the substrate, a size of the first channel in the first direction is larger than that in the second direction, a size of the second channel in the first direction is smaller than that in the second direction, and the size of the first channel in the first direction is larger than the size of the second channel in the first direction, where the first direction is perpendicular to the top surface of the substrate, and the second direction is parallel to the top surface of the substrate; and
forming a first gate on at least one of the first surface and the second surface, and forming a second gate on at least one of the third surface and the fourth surface.

According to a sixth aspect, this application provides a semiconductor device preparation method, where the semiconductor device preparation method includes:
forming a plurality of first fins that are parallel to each other and a plurality of second fins that are parallel to each other on a substrate, where the first fins are perpendicular to a top surface of the substrate, the first fins are p-type doped, the second fins are parallel to the top surface of the substrate, and the second fins are n-type doped; and
forming a ridged gate on the top surface of the substrate, and the ridge gate covers a part of a surface of the first fins and the second fins.

### BRIEF DESCRIPTION OF DRAWINGS

FIG. 1 is a schematic diagram of a structure of an inverter according to an implementation of this application;
FIG. 2 is a schematic diagram of a structure of an inverter in a current technology;
FIG. 3 is a schematic diagram of a structure of an inverter in a current technology;
FIG. 4 is a schematic diagram of a structure of an inverter according to an implementation of this application;
FIG. 5 is a schematic diagram of a structure of an inverter according to an implementation of this application;
FIG. 6 is a schematic diagram of a structure of an inverter according to an implementation of this application;
FIG. 7 is a schematic diagram of a structure of an inverter according to an implementation of this application;
FIG. 8 is a schematic diagram of a structure of an inverter according to an implementation of this application;
FIG. 9 is a schematic diagram of a structure of an inverter according to an implementation of this application;
FIG. 10 is a schematic diagram of a structure of an inverter according to an implementation of this application;
FIG. 11 is a schematic diagram of a structure of an inverter according to an implementation of this application;
FIG. 12 is a schematic diagram of a structure of an inverter according to an implementation of this application;
FIG. 13 is a schematic diagram of a structure of an inverter according to an implementation of this application;
FIG. 14 is a flowchart of an inverter preparation method according to an implementation of this application;
FIG. 15 is a schematic diagram of an inverter in a preparation process according to an implementation of this application;
FIG. 16 is a schematic diagram of an inverter in a preparation process according to an implementation of this application;
FIG. 17 is a schematic diagram of an inverter in a preparation process according to an implementation of this application;
FIG. 18a is a three-dimensional schematic diagram of an inverter in a preparation process according to an implementation of this application;
FIG. 18b is a sectional view of A-A in FIG. 18a of this application;
FIG. 19a is a three-dimensional schematic diagram of an inverter in a preparation process according to an implementation of this application;
FIG. 19b is a sectional view of A-A in FIG. 19a of this application;
FIG. 20a is a three-dimensional schematic diagram of an inverter in a preparation process according to an implementation of this application;
FIG. 20b is a sectional view of B-B in FIG. 20a of this application;
FIG. 21a is a three-dimensional schematic diagram of an inverter in a preparation process according to an implementation of this application;
FIG. 21b is a sectional view of B-B in FIG. 21a of this application;
FIG. 22a is a three-dimensional schematic diagram of an inverter in a preparation process according to an implementation of this application;
FIG. 22b is a sectional view of B-B in FIG. 22a of this application;
FIG. 23a is a three-dimensional schematic diagram of an inverter in a preparation process according to an implementation of this application;
FIG. 23b is a sectional view of B-B in FIG. 23a of this application;
FIG. 24a is a three-dimensional schematic diagram of an inverter in a preparation process according to an implementation of this application;
FIG. 24b is a sectional view of B-B in FIG. 24a of this application;
FIG. 25a is a three-dimensional schematic diagram of an inverter in a preparation process according to an implementation of this application;
FIG. 25b is a sectional view of B-B in FIG. 25a of this application;
FIG. 25c is a sectional view of C-C in FIG. 25a of this application;
FIG. 26a is a three-dimensional schematic diagram of an inverter in a preparation process according to an implementation of this application;
FIG. 26b is a sectional view of B-B in FIG. 26a of this application;
FIG. 26c is a sectional view of C-C in FIG. 26a of this application;
FIG. 26d is a sectional view of D-D in FIG. 26a of this application;
FIG. 27a is a three-dimensional schematic diagram of an inverter in a preparation process according to an implementation of this application;
FIG. 27b is a sectional view of A-A in FIG. 27a of this application;
FIG. 28a is a three-dimensional schematic diagram of an inverter in a preparation process according to an implementation of this application;
FIG. 28b is a sectional view of A-A in FIG. 28a of this application;
FIG. 29a is a three-dimensional schematic diagram of an inverter according to an implementation of this application;
FIG. 29b is a sectional view of B-B in FIG. 29a of this application;
FIG. 30 is an equivalent circuit board of an inverter according to an implementation of this application;
FIG. 31a is a three-dimensional schematic diagram of an inverter in a preparation process according to an implementation of this application;
FIG. 31b is a sectional view of A-A in FIG. 31a of this application;
FIG. 32 is a three-dimensional schematic diagram of an inverter in a preparation process according to an implementation of this application; and
FIG. 33 is a three-dimensional schematic diagram of an inverter in a preparation process according to an implementation of this application.

### DESCRIPTION OF EMBODIMENTS

In this specification, terms "first", "second", and the like are merely used for a purpose of description, and shall not be understood as an indication or implication of relative importance or implicit indication of a quantity of indicated technical features. Therefore, a feature limited by "first" or "second" may explicitly or implicitly include one or more of the features. In the descriptions of this application, unless otherwise stated, "a plurality of" means two or more than two.

In addition, in this specification, orientation terms such as "up" and "down" are defined with respect to orientations of schematically placed structures in the accompanying drawings. It should be understood that these orientation terms are relative concepts and are used for relative description and clarification. The orientation terms may vary correspondingly based on a change in an orientation in which the structure is placed.

For ease of understanding, the following first explains and describes English abbreviations and related technical terms in embodiments of this application.

CFET: Complementary Field Effect Transistor, complementary field effect transistor.

SOC: spin-on carbon, spin-on carbon, a medium material.

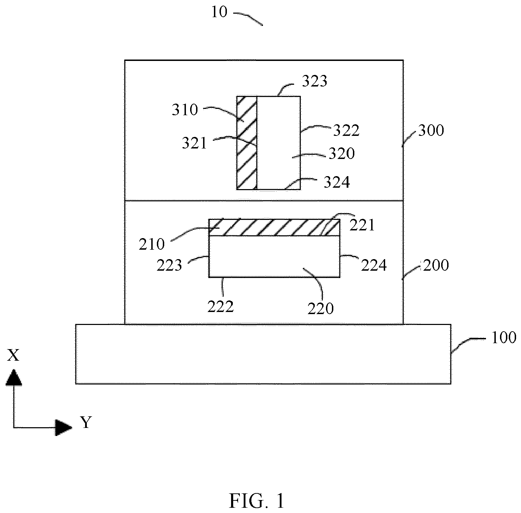

Refer to FIG. 1. An implementation of this application provides an inverter 10, where the inverter 10 includes a substrate 100, and an n-type field effect transistor 200 and a p-type field effect transistor 300 that are located on a top surface of the substrate 100 and that are stacked along a first direction X, where the p-type field effect transistor 300 includes a first gate 310 and a first channel 320, and the n-type field effect transistor 200 includes a second gate 210 and a second channel 220.

Each of the first channel 320 and the second channel 220 includes a crystal plane (110) perpendicular to the top surface of the substrate 100 and a crystal plane (100) parallel to the top surface of the substrate 100, where a size of the first channel 320 in the first direction X is larger than that in a second direction Y, a size of the second channel 220 in the first direction X is smaller than that in the second direction Y, and the size of the first channel 320 in the first direction X is larger than the size of the second channel 220 in the first direction X, where the first direction X is perpendicular to the top surface of the substrate 100, and the second direction Y is parallel to the top surface of the substrate 100. The first channel 320 may also be referred to as a first fin 320, and the second channel 220 may also be referred to as a second fin 220.

The first channel 320 includes a first surface 321 and a second surface 322 that are disposed oppositely and that both include the crystal plane (110), where the first surface 321 and the second surface 322 are arranged along the second direction Y, and the first gate 310 covers at least one of the first surface 321 and the second surface 322; and the second channel 220 includes a third surface 221 and a fourth surface 222 that are disposed oppositely and that both include the crystal plane (100), where the third surface 221 and the fourth surface 222 are arranged along the first direction X, and the second gate 210 covers at least one of the third surface 221 and the fourth surface 222.

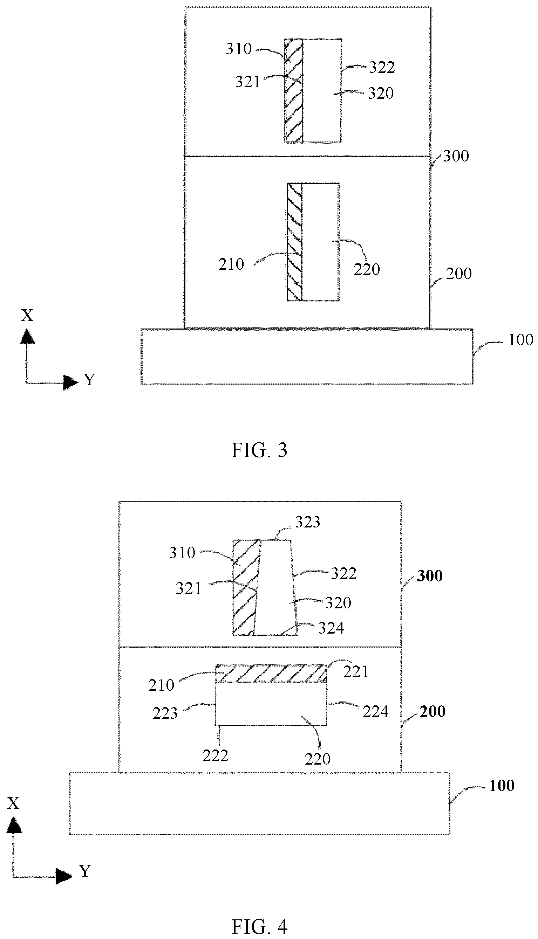

The size of the first channel 320 in the first direction X is a longest distance between two ends of the first channel 320 in the first direction X, and the size of the first channel 320 in the second direction Y is a longest distance between two ends of the first channel 320 in the second direction Y For example, when a sectional plane of the first channel 320 is a rectangle (as shown in FIG. 1), a size of the first channel 320 along the first direction X is the length of the rectangle, and a size of the first channel 320 along the second direction Y is the width of the rectangle, where the section plane of the first channel 320 is a section plane obtained by cutting the first channel 320 at a line perpendicular to the first channel 320. For another example, when the sectional plane of the first channel 320 is a trapezoid (as shown in FIG. 4), the top edge and the bottom edge of the trapezoid are parallel to the second direction Y, and the length of the bottom edge in the second direction Y is larger than the length of the top edge in the second direction Y In other words, the length of the bottom edge in the second direction Y is the longest distance between the two ends of the first channel 320 in the second direction Y In this case, the size of the first channel 320 in the first direction X is the height between the top edge and the bottom edge of the trapezoid, and the size of the first channel 320 in the second direction Y is the length of the bottom edge of the trapezoid in the second direction Y

The size of the second channel 220 in the first direction X is a longest distance between two ends of the second channel 220 in the first direction X, and the size of the second channel 220 in the second direction Y is a longest distance between two ends of the second channel 220 in the second direction Y

The top surface of the substrate 100 is a surface of the substrate 100 close to the first channel 320 and the second channel 220.

Materials of the first channel 320 and the second channel 220 are single crystal semiconductors, including at least one of SI, Ge, SiGe, GaAs, InSb, GaP, GaSb, InAlAs, InGaAs, GaSbP, GaAsSb, and InP. Selection and proportioning of these materials are not limited in this application, provided that the first channel 320 includes the crystal plane (110) that is conducive to electron hole transmission and that is perpendicular to the top surface of the substrate 100, and that the second channel 220 includes the crystal plane (100) that is conducive to electron transmission and that is parallel to the top surface of the substrate 100. In this application, the first channel 320 of the p-type field effect transistor 300 is a p-type channel, or the first channel 320 is p-type doped, and current carriers of the p-type channel are electron holes. The size of the first channel 320 in the first direction X is set to be larger than that in the second direction Y In this way, an area of the first surface 321 and the second surface 322 that both include the crystal plane (110) are larger than an area of surfaces of the first channel 320 that are disposed oppositely in the second direction Y, so that electron hole mobility of the p-type field effect transistor 300 is high, and performance of the p-type field effect transistor 300 can be improved. The second channel 220 of the n-type field effect transistor 200 is an n-type channel, or the second channel 220 is n-type doped, and current carriers of the n-type channel are electrons. The size of the second channel 220 in the first direction X is set to be smaller than that in the second direction Y In this way, an area of the third surface 221 and the fourth surface 222 that both include the crystal plane (100) are larger than an area of surfaces of the second channel 220 that are disposed oppositely in the first direction X, so that electron mobility of the n-type field effect transistor 200 is high, and performance of the n-type field effect transistor 200 can be improved.

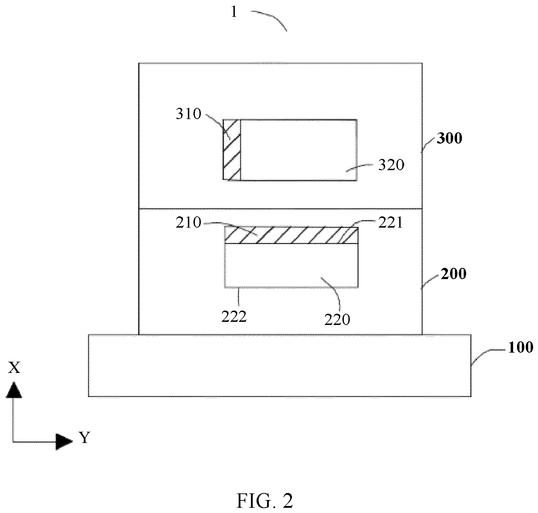

In comparison with a p-type field effect transistor 300 of an inverter 1 in FIG. 2, the p-type field effect transistor 300 of the inverter 10 in this application has a higher electron hole mobility. The inverter 1 shown in FIG. 2 includes an n-type field effect transistor 200 and the p-type field effect transistor 300, where an n-type channel 220 of the n-type field effect transistor 2 is parallel to a top surface of a substrate 100, a p-type channel 320 of the p-type field effect transistor 300 is parallel to the top surface of the substrate 100, and a size of the p-type channel 320 of the p-type field effect transistor 300 in a first direction X is smaller than that in a second direction Y, so that an area of two surfaces of the p-type channel 320 that are disposed oppositely in the second direction Y is smaller than an area of two surfaces of the p-type channel 320 that are disposed oppositely in the first direction X. In other words, an area of surfaces that include the crystal plane (110) and that are conducive to electron hole transmission becomes smaller, so that an electron hole transmission rate of the p-type channel 320 of the p-type field effect transistor 300 is poor, and performance in the inverter 1 is further affected.

In this application, the n-type field effect transistor 200 and the p-type field effect transistor 300 are stacked and disposed on the substrate 100 along the first direction X, so that the inverter 10 has a small size, and miniaturization performance of the inverter 10 can be improved. In comparison with a size of an inverter 1 in FIG. 3, a size of the inverter 10 in this application in the first direction X can be greatly reduced. For example, for the inverter 1 shown in FIG. 3, the n-type channel of the n-type field effect transistor 2 and the p-type channel of the p-type field effect transistor 3 are perpendicular to the substrate 100, so that the inverter 1 has a large size in the first direction X and has poor miniaturization performance.

The inverter 10 provided in this application can improve electron hole mobility in the first channel 320 of the p-type field effect transistor 300, and improve electrical performance of the inverter 10. In addition, the n-type field effect transistor 200 and the p-type field effect transistor 300 are stacked and disposed on the substrate 100 in the first direction X, and the miniaturization performance of the inverter 10 can be improved.

Still with reference to FIG. 1, in this implementation, the first gate 310 covers the first surface 321, the second gate 210 covers the third surface 221, and the third surface 221 is disposed farther away from the substrate 100 compared with the fourth surface 222. The first surface 321 and the second surface 322 are perpendicular to the top surface of the substrate 100, and the third surface 221 and the fourth surface 222 are parallel to the top surface of the substrate 100.

In this implementation, the first channel 320 further includes a fifth surface 323 and a sixth surface 324 that are disposed oppositely, where the fifth surface 323 and the sixth surface 324 are arranged along the first direction X, the first surface 321, the fifth surface 323, the second surface 322, and the sixth surface 324 are sequentially connected, the first surface 321 and the second surface 322 are perpendicular to the top surface of the substrate 100, the fifth surface 323 and the sixth surface 324 are parallel to the top surface of the substrate 100, the fifth surface 323 is disposed farther away from the substrate 100 compared with the sixth surface 324, and the first gate 310 covers only the first surface 321. The second channel 220 further includes a seventh surface 223 and an eighth surface 224 that are disposed oppositely, where the seventh surface 223 and the eighth surface 224 are arranged along the second direction Y, the third surface 221, the eighth surface 224, the fourth surface 222, and the seventh surface 223 are sequentially connected, the seventh surface 223 and the eighth surface 224 are perpendicular to the top surface of the substrate 100, and the second gate 210 covers only the third surface 221.

Refer to FIG. 4. Different from the implementation shown in FIG. 1, in a possible implementation, a first surface 321 and a second surface 322 separately intersect with a top surface of a substrate 100, and both a fifth surface 323 and a sixth surface 324 are parallel to the top surface of the substrate 100. A section plane of a first channel 320 is a trapezoid, the section plane of the first channel 320 is a section plane obtained by cutting the first channel 320 at a line perpendicular to the first channel 320, and the section plane of the first channel 320 is in a shape that is narrower in the top and wider in the bottom. In other words, a size of an end of the first channel 320 close to the substrate 100 is the largest. Therefore, in this implementation, the size of the first channel 320 in a second direction Y is the size of the end of the first channel 320 close to the substrate 100. The size of the first channel 320 in a first direction X is a distance between the fifth surface 323 and the sixth surface 324.

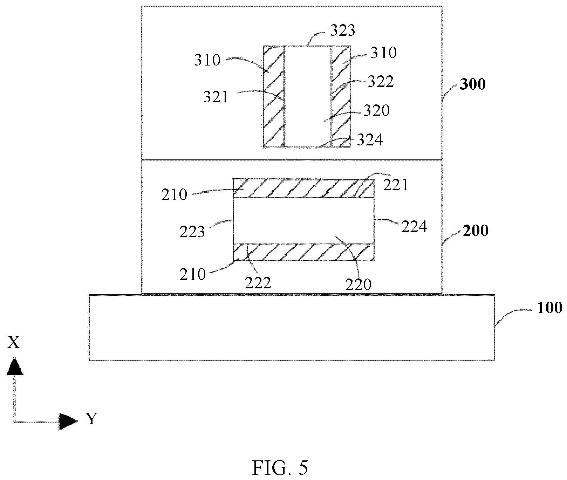

Refer to FIG. 5. Different from the implementation shown in FIG. 1, in a possible implementation, a first gate 310 covers a first surface 321 and a second surface 322. A second gate 210 covers a third surface 221 and a fourth surface 222.

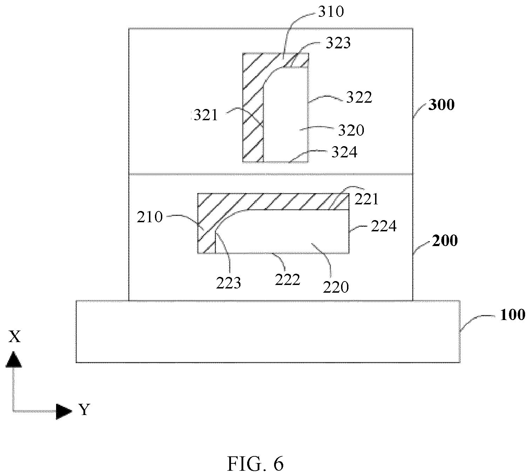

Refer to FIG. 6. Different from the implementation shown in FIG. 1, in a possible implementation, a first gate 310 covers a first surface 321 and a fifth surface 323. A second gate 210 covers a third surface 221 and a seventh surface 223. In addition, in this implementation, an intersection position between the first surface 321 and the fifth surface 323 is an arc-shaped transition, and an intersection position between the third surface 221 and the seventh surface 223 is an arc-shaped transition. In an implementation, an intersection position between the second surface 322 and the fifth surface 323 is an arc-shaped transition, and an intersection position between the fourth surface 222 and the seventh surface 223 is an arc-shaped transition.

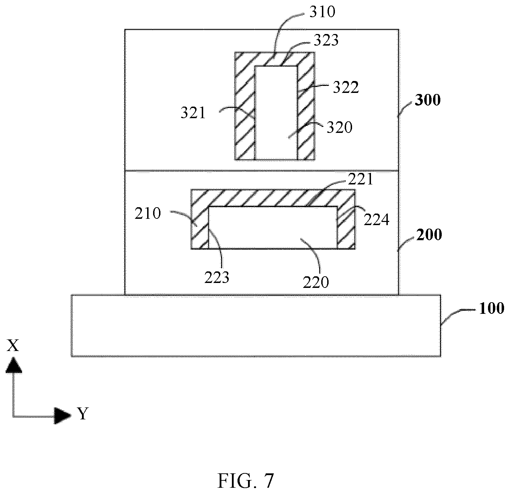

Refer to FIG. 7. Different from the implementation shown in FIG. 1, in a possible implementation, a first gate 310 further covers at least one of a fifth surface 323 and a sixth surface 324, and a second gate 210 further covers at least one of a seventh surface 223 and an eighth surface 224. In this implementation, the first gate 310 covers a first surface 321, a second surface 322, and the fifth surface 323, and the second gate 210 further covers a third surface 221, the seventh surface 223, and the eighth surface 224, to form a three-sided gate structure of a first channel 320 and a second channel 220.

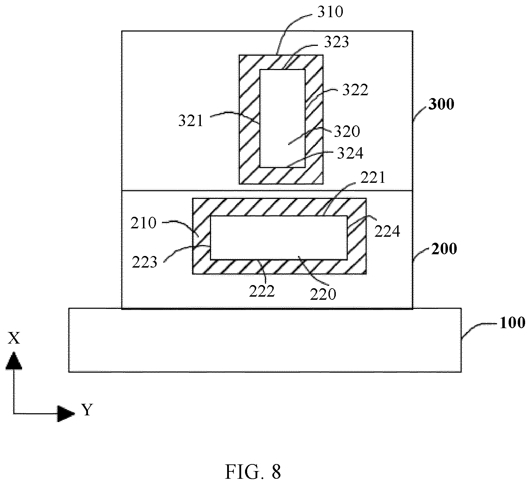

Refer to FIG. 8. Different from the implementation shown in FIG. 1, in a possible implementation, a first gate 310 covers a first surface 321, a second surface 322, a fifth surface 323, and a sixth surface 324, to form a four-sided gate structure of a first channel 320. A second gate 210 covers a third surface 221, a fourth surface 222, a seventh surface 223, and an eighth surface 224, to form a four-sided gate structure of a second channel 220. In this implementation, the first gate 310 and the second gate 210 are also referred to as ridged gates erected on a top surface of a substrate 100, the first channel 320 is also referred to as a first fin 320, the second channel 220 is also referred to as a second fin 220, and the first fin 320 and the second fin 220 pass through the gates, where a partial structure that is of the first fin 320 and that is surrounded by the gate is p-type doped, and a partial structure that is of the second fin 220 and that is surrounded by the gate is n-type doped.

In this implementation, an n-type field effect transistor 200 is located on a side of the substrate 100, and a p-type field effect transistor 300 is located on a side that is of the n-type field effect transistor 200 and that is away from the substrate 100. That is, the p-type field effect transistor 300 is located above the n-type field effect transistor 200.

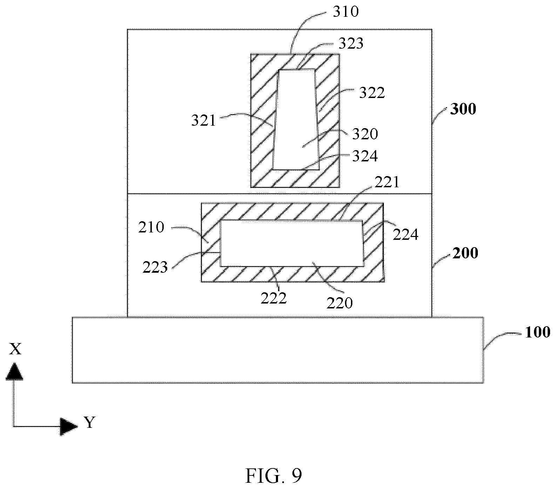

Refer to FIG. 9. Different from the implementation shown in FIG. 8, a section plane of a first channel 320 is a trapezoid, and a section plane of a second channel 220 is a rectangle.

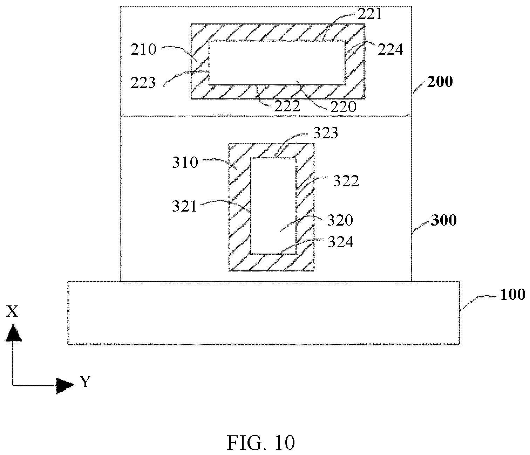

Refer to FIG. 10. Different from the implementation shown in FIG. 8, a p-type field effect transistor 300 is located on a side of a substrate 100, and an n-type field effect transistor 200 is located on a side that is of the p-type field effect transistor 300 and that is away from the substrate 100. That is, the n-type field effect transistor 200 is located above the p-type field effect transistor 300.

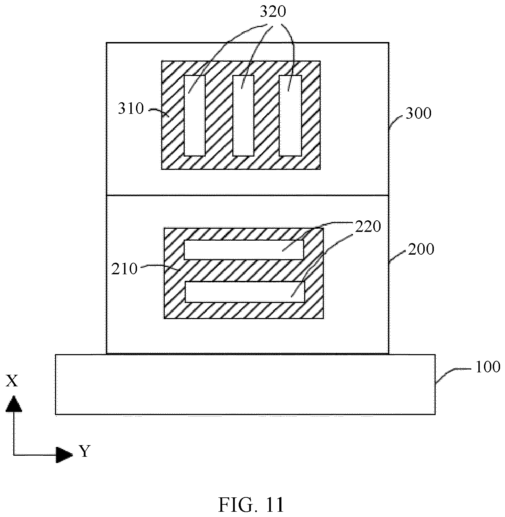

Refer to FIG. 11. Different from the implementation shown in FIG. 8, there are at least two first channels 320, and the at least two first channels 320 are arranged and disposed at intervals along a second direction Y; and there are at least two second channels 220, and the at least two second channels 220 are arranged and disposed at intervals along a first direction X. In this implementation, there are three first channels 320 and two second channels 220, the three first channels 320 are all four-sided gate structures, and the two second channels 220 are both four-sided gate structures. In some other implementations, a quantity of the first channels 320 and a quantity of the second channels 220 may be set based on an actual requirement, and the quantity of the first channels 320 and the quantity of the second channels 220 may be the same or different. When there are a plurality of first channels 320 and second channels 220, each first channel 320 may have a different size in the second direction Y, and each second channel 220 may have a different size in the first direction X, so that a structure design is more flexible.

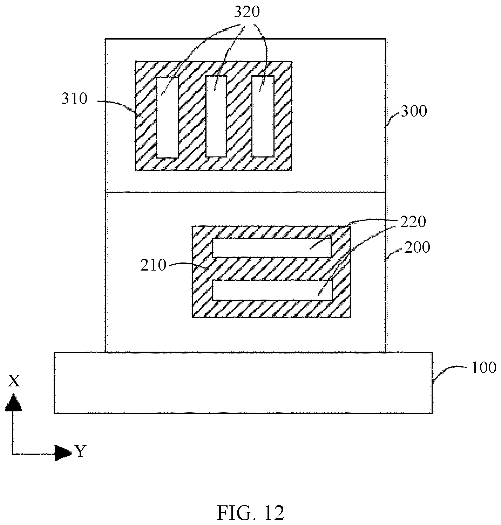

Refer to FIG. 12. Different from the implementation shown in FIG. 11, orthographic projections of a first channel 320 and a second channel 220 on a substrate 100 do not overlap at least partially. In other words, in this implementation, a central axis of the first channel 320 and a central axis of the second channel 220 may not overlap, and the two may be disposed in a misplaced manner, so that a process difficulty is reduced.

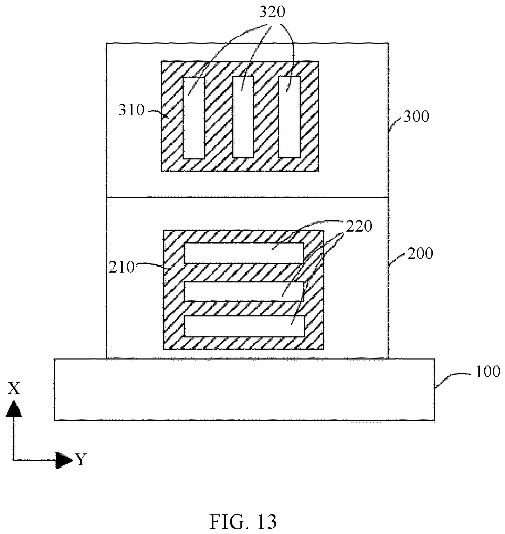

Refer to FIG. 13. Different from the implementation shown in FIG. 11, a quantity of first channels 320 and a quantity of second channels 220 are the same, there are three first channels 320 and three second channels 220, and the three first channels 320 and the three second channels 220 are all four-sided gate structures. In this implementation, a first gate 310 and a second gate 210 are also referred to as ridged gates erected on a top surface of a substrate 100, a first channel 320 is also referred to as a first fin, and a second channel 220 is also referred to as a second fin, the first fin 320 and the second fin 220 pass through the gates, the plurality of first fins 320 are parallel to each other, and the first fins are perpendicular to the top surface of the substrate 100, where the partial structure that is of the first fins 320 and that is surrounded by the gate is p-type doped; and the plurality of second fins 220 are parallel to each other, and the second fins 220 are parallel to the top surface of the substrate 100, where the partial structure that is of the second fins 220 and that is surrounded by the gate is n-type doped. In this implementation, the first fin 320 and the second fin 220 are flat, and that the plurality of first fins 320 are parallel to each other means that overall extension directions of the first fins 320 are parallel to each other. A first surface 321 and a second surface 322 of the first fin 320 are perpendicular to the top surface of the substrate 100, and that the plurality of second fins 220 are parallel to each other means that overall extension directions of the second fins 220 are parallel to each other. A third surface 221 and a fourth surface 222 of the second fin 220 are parallel to the top surface of the substrate 100.

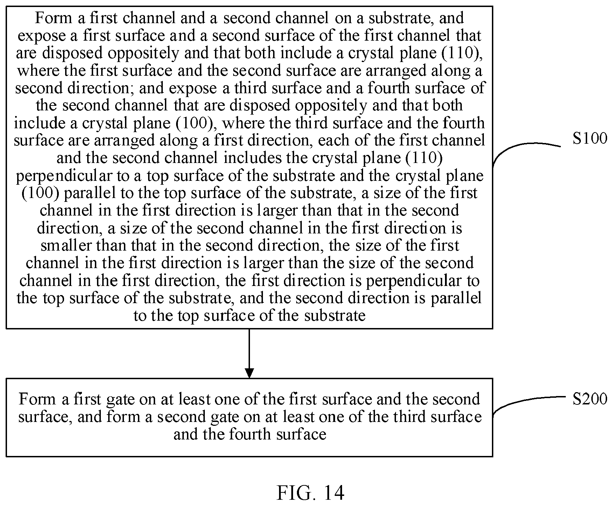

With reference to FIG. 14 to FIG. 29b, the following describes other structural compositions and a preparation method of the inverter 10 in the embodiment shown in FIG. 13. The inverter 10 in the foregoing implementations in FIG. 1 and FIG. 4 to FIG. 12 may be similar to the another structure of the inverter 10 in the implementation shown in FIG. 13, and may be adaptively deformed when a function of the inverter 10 can be implemented.

Refer to FIG. 14. An implementation of this application further provides an inverter 10 preparation method. The inverter preparation method includes at least step S 100 and step S200. Detailed steps are as follows.

Step S100: Form a first channel 320 in a p-type field effect transistor 300 and a second channel 220 in an n-type field effect transistor 200 on a substrate 100, expose a first surface 321 and a second surface 322 of the first channel 320 that are disposed oppositely and that both include a crystal plane (110), where the first surface 321 and the second surface 322 are arranged along a second direction Y; and expose a third surface 221 and a fourth surface 222 of the second channel 220 that are disposed oppositely and that both include a crystal plane (100), where the third surface 221 and the fourth surface 222 are arranged along a first direction X, each of the first channel 320 and the second channel 220 includes the crystal plane (110) perpendicular to a top surface of the substrate 100 and the crystal plane (100) parallel to the top surface of the substrate 100, a size of the first channel 320 in the first direction X is larger than that in the second direction Y, a size of the second channel 220 in the first direction X is smaller than that in the second direction Y, and the size of the first channel 320 in the first direction X is larger than the size of the second channel 220 in the first direction X, where the first direction X is perpendicular to the top surface of the substrate 100, and the second direction Y is parallel to the top surface of the substrate 100.

Step S200: Form a first gate 310 on at least one of the first surface 321 and the second surface 322, and form a second gate 210 on at least one of the third surface 221 and the fourth surface 222.

In this implementation, the first surface 321 and the second surface 322 in the first channel 320 that are formed have a large area size, and the crystal planes (110) in the first surface 321 and the second surface 322 are conducive to electron hole migration, so that electron hole mobility in the p-type field effect transistor 300 can be improved, comprehensive performance of the inverter 10 can be improved. The size of the second channel 220 in the n-type field effect transistor 200 in the first direction X is smaller than that in the second direction Y, so that a size of the inverter 10 in the first direction X can be reduced, and miniaturization performance of the inverter 10 is improved.

In this implementation, detailed steps of the inverter 10 preparation method are described as follows.

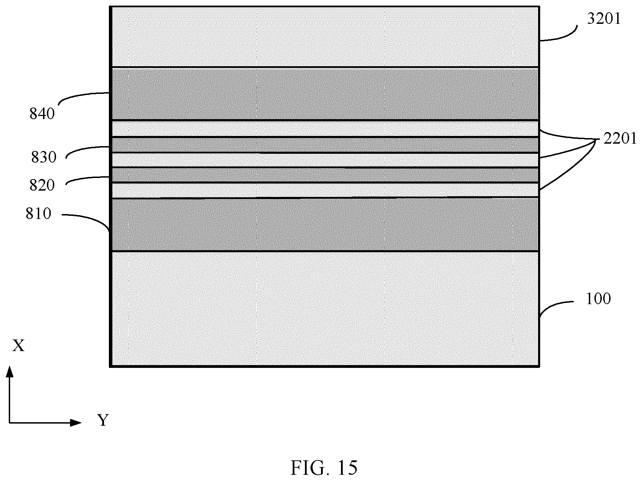

Step S 1: As shown in FIG. 15, epitaxially form a sacrificial layer and a channel original layer that are stacked in a misplaced manner on the substrate 100. Specifically, four sacrificial layers are formed on the substrate 100, including a first sacrificial layer 810, a second sacrificial layer 820, a third sacrificial layer 830, and a fourth sacrificial layer 840, and three second channel original layers 2201 and one first channel original layer 3201 are formed, where the three second channel original layers 2201 are separately located between two of the four sacrificial layers, and the first channel 3201 is located on a side that is of the fourth sacrificial layer 840 and that is away from the substrate 100. The second channel original layer 2201 is also referred to as a second fin original layer 2201, and the first channel original layer 3201 is also referred to as a first fin original layer 3201.

The three second channel original layers 2201 are original layers for forming the second channel 220, and the second channel 220 is obtained by subsequent etching, where the second channel 220 is also referred to as a second fin. The three second channel original layers 2201 may have the same or different sizes in the first direction X. A size of the first channel original layer 3201 in the first direction X is larger than the size of the second channel 220 in the first direction X. The first channel original layer 3201 is an original layer for forming the first channel 320, and the first channel 320 is obtained by subsequent etching, where the first channel 320 is also referred to as a first fin. In this implementation, three first channels 320 are to be formed, where sizes of the three first channels 320 in the second direction Y may be the same or different. The sizes of the first channel 320 and the second channel 220 in the first direction X may be determined in this step. In other implementations, a quantity of layers of the second channel original layer 2201 and the sacrificial layer may be adjusted based on a quantity of second channels 220 in the inverter 10.

Materials of the first sacrificial layer 810, the second sacrificial layer 820, the third sacrificial layer 830, and the fourth sacrificial layer 840 may be at least one of SI, Ge, SiGe, GaAs, InSb, GaP, GaSb, InAlAs, InGaAs, GaSbP, GaAsSb, and InP.

Materials of the second channel original layer 2201 and the first channel original layer 3201 are single crystal semiconductors, and may be at least one of SI, Ge, SiGe, GaAs, InSb, GaP, GaSb, InAlAs, InGaAs, GaSbP, GaAsSb, and InP. Each of the second channel original layer 2201 and the first channel original layer 3201 includes the crystal plane (110) perpendicular to the top surface of the substrate 100 and the crystal plane (100) parallel to the top surface of the substrate 100. In this implementation, each of the second channel original layer 2201 and the first channel original layer 3201 is parallel to the top surface of the substrate 100, so that the crystal planes (110) in the second channel original layer 2201 and the first channel original layer 3201 are perpendicular to the second channel original layer 2201 and the first channel original layer 3201, and the crystal planes (100) are parallel to the second channel original layer 2201 and the first channel original layer 3201. In this step, surfaces that are of the first channel original layer 3201 and the second channel original layer 2201 and are arranged and disposed along the first direction X, and that are parallel to the second direction Y include the crystal plane (100).

A material of the substrate 100 may be at least one of SI, Ge, SiGe, GaAs, InSb, GaP, GaSb, InAlAs, InGaAs, GaSbP, GaAsSb, and InP.

Methods for forming the sacrificial layer and the channel original layer include methods of chemical vapor deposition (CVD), atomic layer deposition (ALD), and molecular beam epitaxy (MBE).

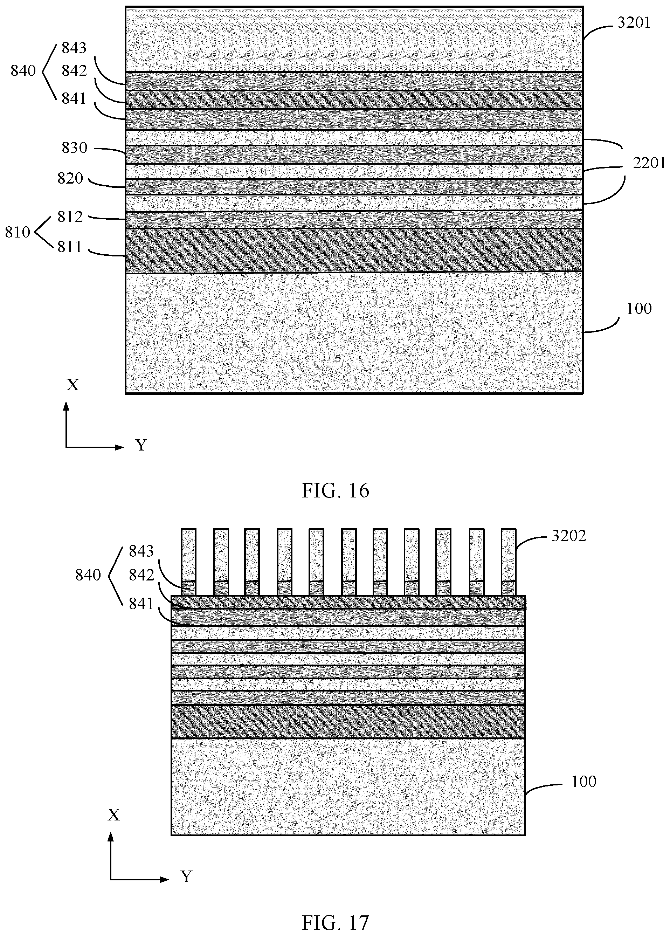

As shown in FIG. 16, in this implementation, materials of the first sacrificial layer 810 and the fourth sacrificial layer 840 are set to be SiGe layers with a high germanium content. In a subsequent process, isolation between the substrate 100 and the second channel 220 or between the second channel 220 and the first channel 320 is implemented by removing the SiGe layers with a high germanium content and filling an insulating medium correspondingly. The isolation can also be implemented by adjusting other materials. In this implementation, the first sacrificial layer 810 includes a first sacrificial sub-layer 811 and a second sacrificial sub-layer 812, and the first sacrificial sub-layer 811 is disposed close to the substrate 100 compared with the second sacrificial sub-layer 812, where the first sacrificial sub-layer 811 is the SiGe layer with a high germanium content, and the SiGe layer with a high germanium content has a higher etching speed, and the first sacrificial sub-layer 811 is subsequently removed and filled with the insulating medium to isolate the substrate 100 from the second channel 220. The fourth sacrificial layer 840 includes a third sacrificial sub-layer 841, a fourth sacrificial sub-layer 842, and a fifth sacrificial sub-layer 843 that are sequentially stacked, where the fourth sacrificial sub-layer 842 located in the middle is the SiGe layer with a high germanium content, and the fourth sacrificial sub-layer 842 is subsequently removed and filled with the insulating medium to isolate the second channel 220 from the first channel 320. Because a portion of the first sacrificial layer 810 and the fourth sacrificial layer 840 needs to be subsequently removed to fill with the insulating medium, it is necessary to set sizes of the first sacrificial layer 810 and the fourth sacrificial layer 840 in the first direction X larger than sizes of the second sacrificial layer 820 and the third sacrificial layer 830 in the first direction X.

Step S2: As shown in FIG. 17, etch the first channel original layer 3201 to form a first channel original layer fin 3202 that has a fin shape. In this case, the first channel original layer fin 3202 is not the final first channel 320, and a size of the first channel original layer fin 3202 in the second direction Y is the size of the first channel 320 in the second direction Y Therefore, in this step, the size of the first channel 320 in the second direction Y can be determined, and two surfaces that are of the first channel original layer fin 3202 and that are disposed oppositely along the second direction Y include the crystal planes (110). In this step, the first channel original layer 3201 to the fifth sacrificial sub-layer 843 are etched to expose a surface of the fourth sacrificial sub-layer 842. In some implementations, the fourth sacrificial sub-layer 842 may not be exposed to retain the fifth sacrificial sub-layer 843, and the fifth sacrificial sub-layer 843 is removed in a subsequent process. In this step, two exposed surfaces that are of the second channel 220 and that are arranged along the second direction Y include the crystal planes (110).

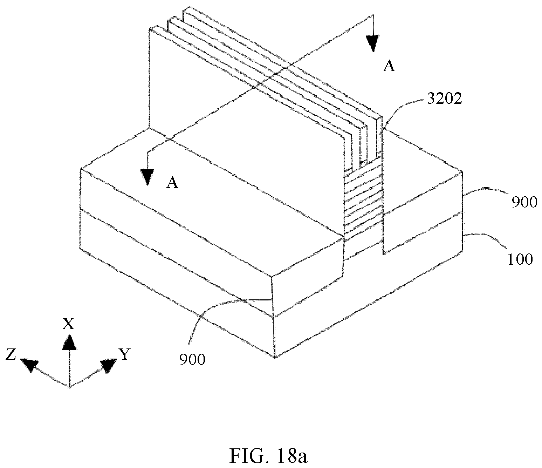

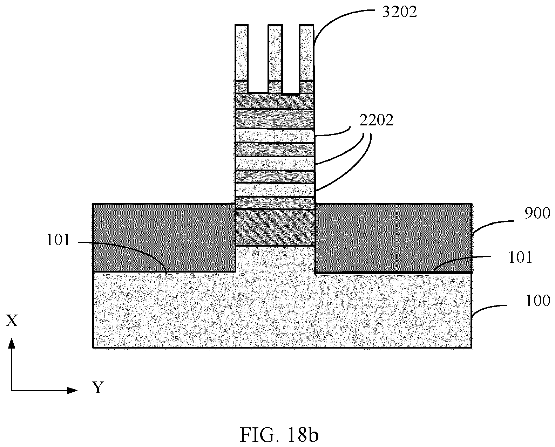

Step S3: As shown in FIG. 18a and FIG. 18b, etch other first channel original layer fins 3202 than the three first channel original layer fins 3202 for forming the first channel 320, so that the other first channel original layer fins 3202 are etched to be lower than the first sacrificial layer 810 and a part of the substrate 100 is etched, to form a trench 101 located on a surface of the substrate 100, and form a shallow trench isolation 900 on a corresponding surface of the trench 101. Specifically, the three first channel original layer fins 3202 located in the middle are retained, and the other first channel original layer fins 3202 located on both sides are etched to be lower than the first sacrificial layer 810 and a part of the substrate 100 is etched. A height of the trench 101 in the first direction X is lower than a height of a surface of the substrate 100 that is not etched, so that a portion of the first sacrificial layer 810 corresponding to the trench 101 is completely etched away. In some other implementations, when there are two first channels 320, two first channel original layer fins 3202 may be retained in this step, and a specific quantity may be set based on an actual requirement.

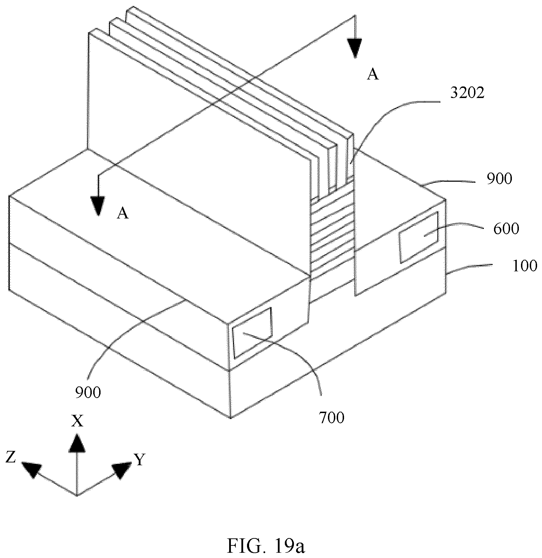

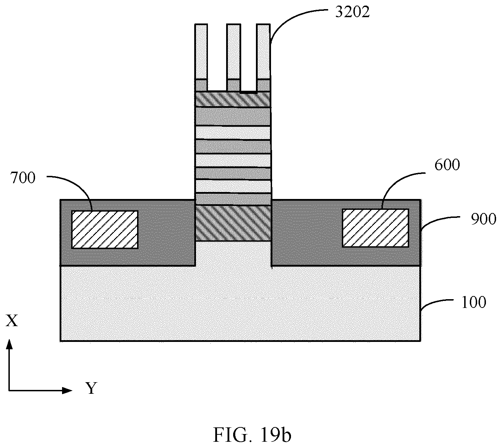

Step S4: As shown in FIG. 19a and FIG. 19b, separately form, in two shallow trench isolations 900, a first voltage end 600 and a second voltage end 700 that extend along a third direction Z. Specifically, buried power rails (buried power rails, BPRs) are separately formed in the two shallow trench isolations 900, where a right BPR is the first voltage end 600 of the inverter 10, and a left BPR is the second voltage end 700 of the inverter 10. The third direction Z, the first direction X, and the second direction Y are perpendicular to each other.

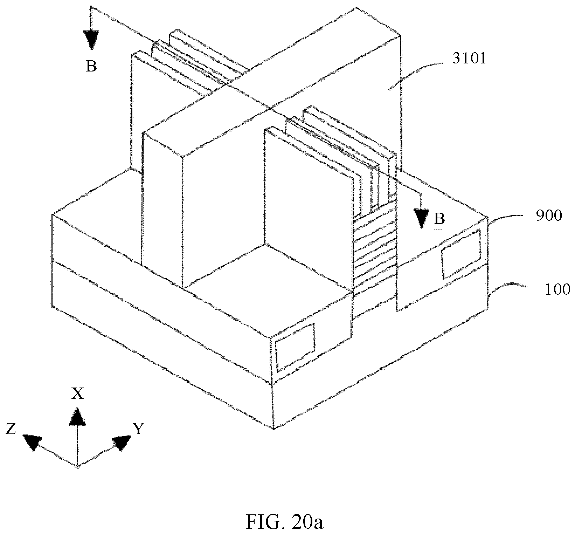

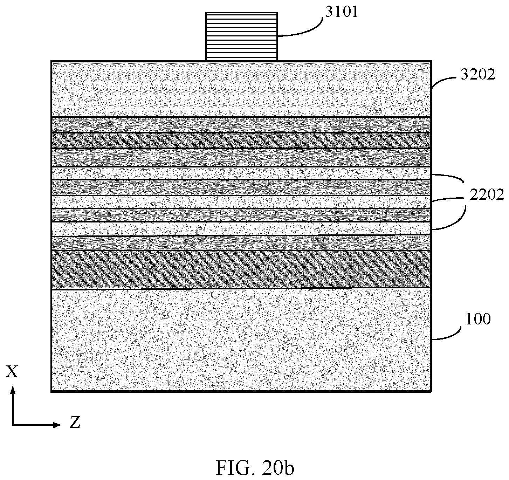

Step S5: As shown in FIG. 20a and FIG. 20b, form a dummy gate 3101 on a side that is of the three first channel original layer fins 3202 and that is away from the substrate 100, where the dummy gate 3101 spans the middle of the three first channel original layer fins 3202 along a second direction Y, and covers the first sacrificial layer 810, the second sacrificial layer 820, the third sacrificial layer 830, the fourth sacrificial layer 840, a part of side walls that are of the second channel original layer 2201 and that are disposed oppositely in the second direction Y, and a part of a surface that is of the shallow trench isolation 900 and that is away from the substrate 100. In this step, the dummy gate 3101 is formed to reserve positions for forming gates of the p-type field effect transistor 300 and the n-type field effect transistor 200 in a subsequent step, and the dummy gate 3101 is subsequently removed to form a truly ridged gate subsequently. In this implementation, a height of the dummy gate 3101 in the first direction X is higher than a height of the first channel original layer fin 3202 in the first direction X, so that a gate-all-around structure is subsequently formed.

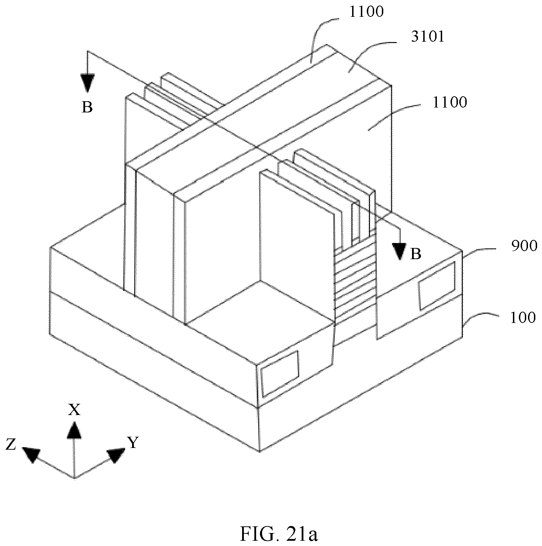

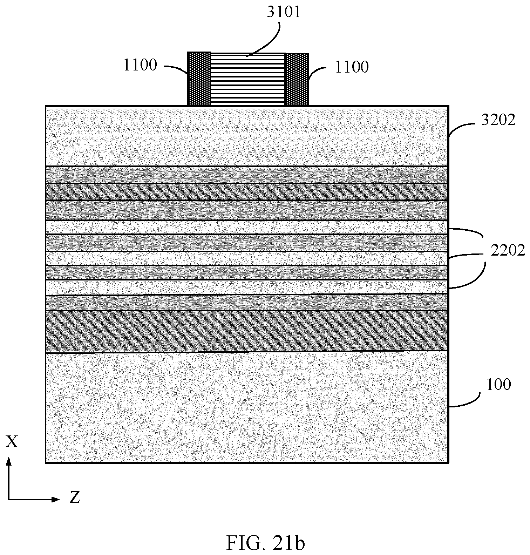

Step S6: As shown in FIG. 21a and FIG. 21b, form first insulation layers 1100 on two sides of the dummy gate 3101 in the third direction Z. The first insulation layer 1100 is configured to isolate a gate, a source, and a drain that are subsequently formed.

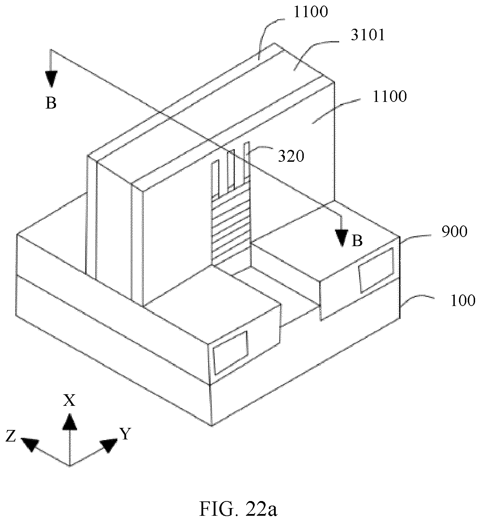

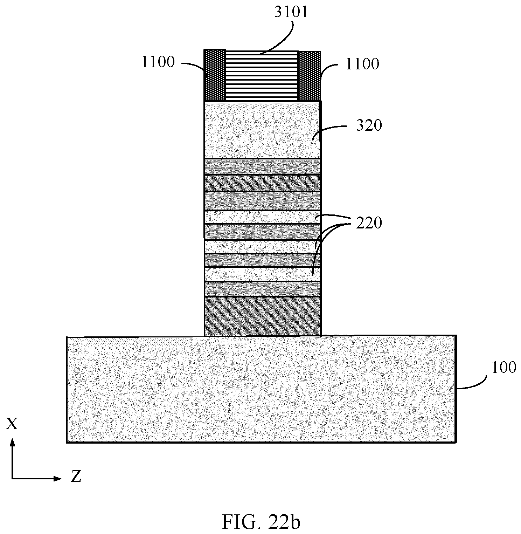

Step S7: As shown in FIG. 22a and FIG. 22b, perform anisotropic etching on the three first channel original layer fins 3202 on a side that is of the first insulation layer 1100 and that is away from the dummy gate 3101, to expose the surface of the substrate 100, and form the first channel 320 and the second channel 220. The anisotropic etching is etching in a direction perpendicular to the substrate 100. In this step, preparation of the first channel 320 and the second channel 220 is completed, and sizes of the first channel 320 and the second channel 220 in the third direction Z are determined.

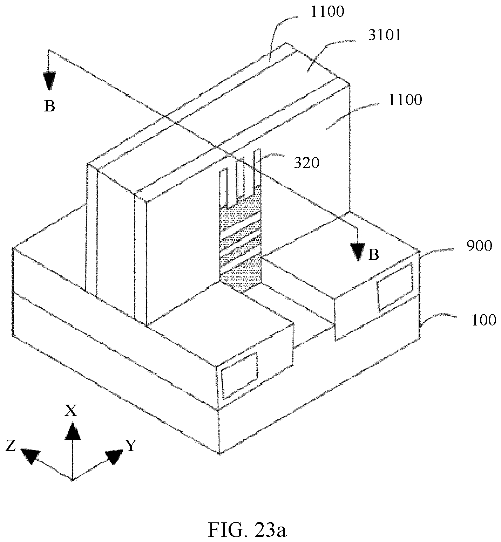

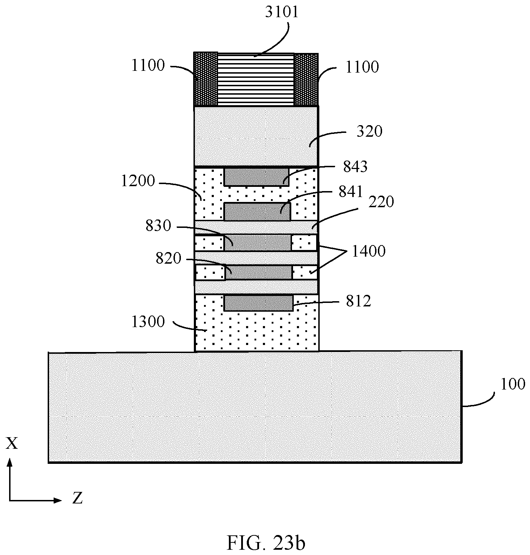

Step S8: As shown in FIG. 23a and FIG. 23b, perform isotropic etching on the first sacrificial layer 810, the second sacrificial layer 820, the third sacrificial layer 830, and the fourth sacrificial layer 840, where when etching the fourth sacrificial layer 840, retain a middle part of the third sacrificial sub-layer 841 and the fifth sacrificial sub-layer 843 (as shown in FIG. 23b), remove a part that is of two ends of the third sacrificial sub-layer 841 and the fifth sacrificial sub-layer 843 in the third direction Z and the fourth sacrificiallayer 842, and fill a removed position with the insulating medium to form a second insulation layer 1200; when etching the first sacrificial layer 810, retain a middle part of the second sacrificial sub-layer 812, remove a part that is of two ends of the second sacrificial sub-layer 812 in the third direction Z and the first sacrificial layer 811, and fill a removed position with the insulating medium to form a third insulation layer 1300; and when etching the second sacrificial layer 820 and the third sacrificial layer 830, retain a middle part of the second sacrificial layer 820 and the third sacrificial layer 830, remove a part that is of two ends of the second sacrificial layer 820 and the third sacrificial layer 830 in the third direction Z, and fill a removed position with the insulating medium to form a fourth insulation layer 1400.

When etching the fourth sacrificial layer 840, because a material of the fourth sacrificial sub-layer 842 includes the SiGe layer with a high Ge content, an etching speed is higher than that of the third sacrificial sub-layer 841 and the fifth sacrificial sub-layer 843. Further, after the fourth sacrificial sub-layer 842 is completely removed, only the two ends of the third sacrificial sub-layer 841 and the fifth sacrificial sub-layer 843 are etched. When etching the first sacrificial layer 810, because a material of the first sacrificial sub-layer 811 includes the SiGe layer with a high Ge content, an etching speed is higher than that of the second sacrificial sub-layer 812. Further, after the first sacrificial sub-layer 811 is completely removed, only the two ends of the second sacrificial sub-layer 812 are etched.

In this step, a remaining sacrificial layer portion is configured to be subsequently removed and filled with gate materials, and the second insulation layer 1200 is configured to isolate the first channel 320 from the second channel 220, or the second insulation layer 1200 is configured to isolate the first fin 320 from the second fin 220. The third insulation layer 1300 may be further configured to isolate the substrate 100 from the second channel 220. The second insulation layer 1200, the third insulation layer 1300, and the fourth insulation layer 1400 are configured to isolate the gate from the source and the drain in the p-type field effect transistor 300 and the n-type field effect transistor 200. The isotropic etching is etching in a direction parallel to the substrate 100.

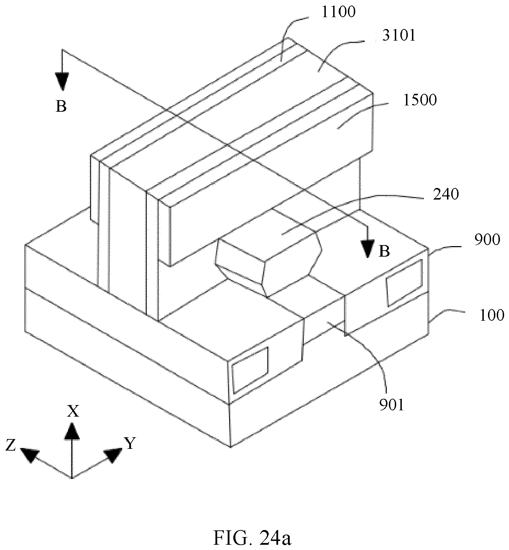

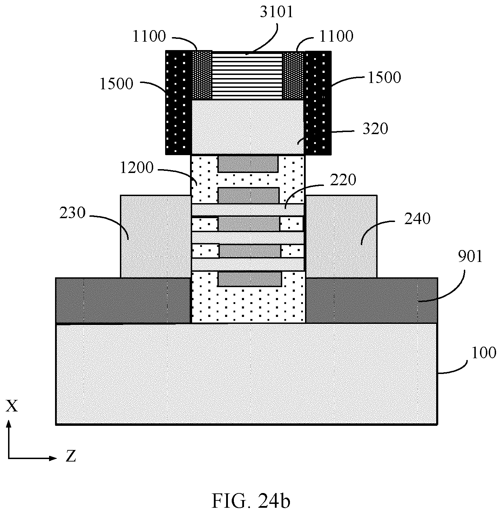

Step S9: As shown in FIG. 24a and FIG. 24b, form a barrier layer 1500 on a side that is of the first insulation layer 1100 and that is away from the dummy gate 3101, where the barrier layer 1500 covers surfaces that are of the first insulation layer 1100 and the first channel 320 in a third direction Z (as shown in FIG. 24b); and separately form a second source 230 and a second drain 240 on two surfaces of the second channel 220 in the third direction Z. In this step, a fifth insulation layer 901 is also formed in the middle of the two shallow trench isolations 900 that are arranged along the second direction X, and the second source 230 and the second drain 240 are formed on the fifth insulation layer 901. A height of the fifth insulation layer 901 in the first direction X is lower than a height of a bottommost second channel 220 close to the surface of the substrate 100, to prevent the fifth insulation layer 901 from covering the bottommost second channel 220, so that the second source 230 and second drain 240 that are formed can be connected to the three second channels 220.

The barrier layer 1500 may be formed by using a SOC deposition method, or may be deposited by using SiC deposition. The barrier layer 1500 is configured to protect the first channel 320 when the second source 230 and the second drain 240 are formed. A material of the second source 230 and the second drain 240 is SiC, and shapes of the second source 230 and the second drain 240 are not limited to shapes in FIG. 24a. This is not limited in this application.

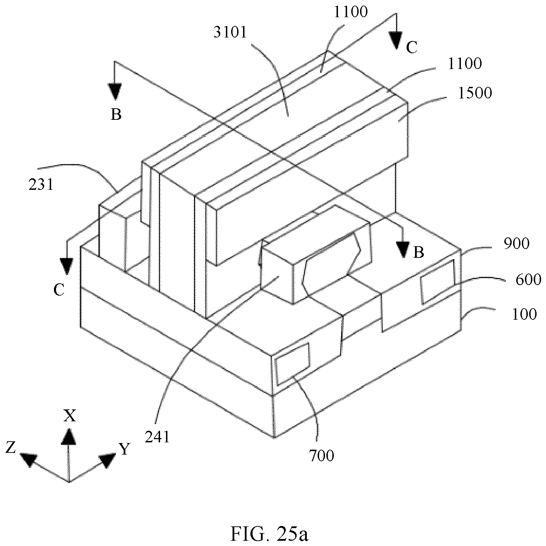

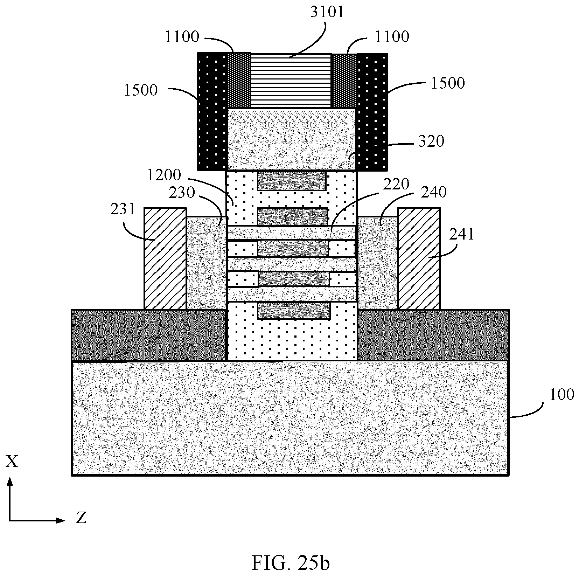

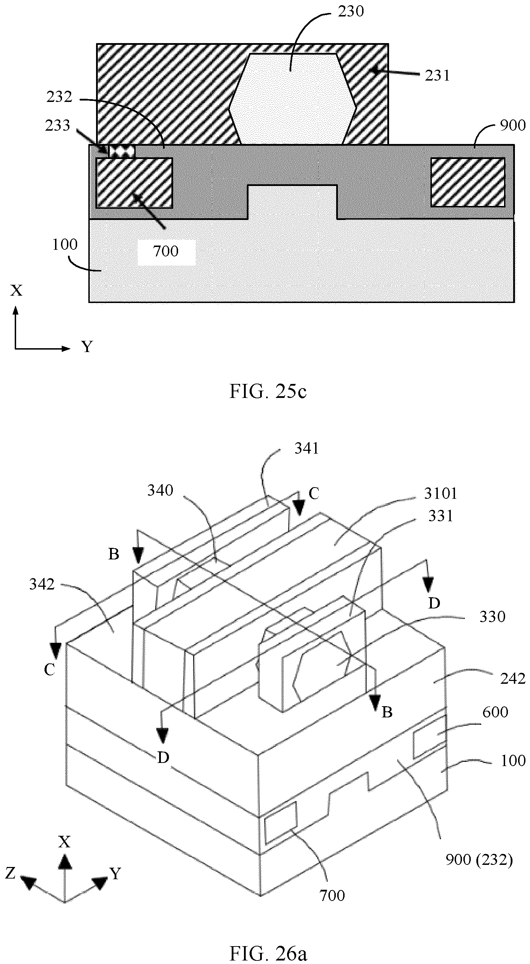

Step S10: As shown in FIG. 25a, FIG. 25b, and FIG. 25c, separately form a first epitaxial structure 231 and a second epitaxial structure 241 on peripheral sides of the second source 230 and the second drain 240, where the first epitaxial structure 230 extends along the second direction Y to above a corresponding second voltage end 700 (as shown in FIG. 25c), and a first through hole 233 is formed in a first interlayer dielectric layer 232 between the first epitaxial structure 231 and the second voltage end 700, so that the first epitaxial structure 231 is electrically connected to the second voltage end 700. The first interlayer dielectric layer 232 is a partial dielectric layer of the shallow trench isolation 900. In this implementation, the first epitaxial structure 231 is disposed on a peripheral side of the second source 230, the first interlayer dielectric layer 232 is disposed between the first epitaxial structure 231 and the second voltage end 700, the first through hole 233 is disposed in the first interlayer dielectric layer 232, and the first epitaxial structure 231 is electrically connected to the second voltage end 700 through the first through hole 233, so that the second source 230 is electrically connected to the second voltage end 700.

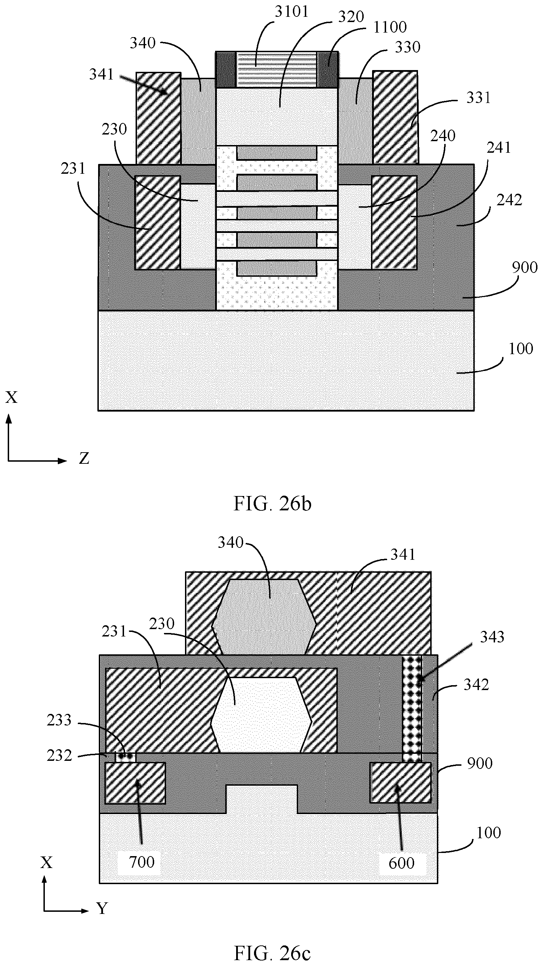

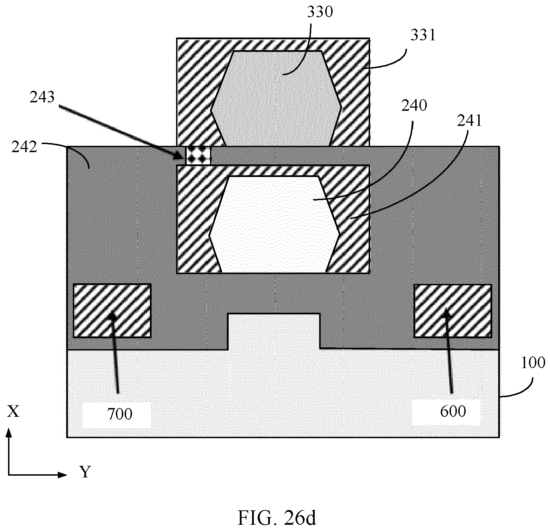

Step S11: As shown in FIG. 26a, FIG. 26b, FIG. 26c, and FIG. 26d, remove the barrier layer 1500, form a second interlayer dielectric layer 342 and a third interlayer dielectric layer 242 on the n-type field effect transistor, and form the first source 330 and the first drain 340 on the side that is of the first insulation layer 1100 and that is away from the dummy gate 3101, where the first drain 340 is located on a surface that is of the second interlayer dielectric layer 342 and that is away from the substrate 100, the first source 330 is located on a surface that is of the third interlayer dielectric layer 242 and that is away from the substrate 100, the first source 330 and the second drain 240 are formed on the same side (as shown in FIG. 26b), and the first drain 340 and the second source 230 are formed on the same side; separately form a third epitaxial structure 331 and a fourth epitaxial structure 341 on the peripheral sides of the first source 330 and the first drain 340, where the fourth epitaxial structure 341 extends along the second direction Y to above a corresponding first voltage end 600 (as shown in FIG. 26a and FIG. 26c); form a second through hole 343 (as shown in FIG. 26c) in the second interlayer dielectric layer 342 between the fourth epitaxial structure 341 and the first voltage end 600, where the fourth epitaxial structure 341 is electrically connected to the first voltage end 600 through the second through hole 343, and the second through hole 343 further penetrates a part of a dielectric layer in the shallow trench isolation 900; and form a third through hole 243 in the third interlayer dielectric layer 242 between the third epitaxial structure 331 and the second epitaxial structure 241, where the third epitaxial structure 331 is electrically connected to the second epitaxial structure 241 through the third through hole 243 (as shown in FIG. 26d).

In this implementation, the fourth epitaxial structure 341 is disposed on the peripheral side of the first drain 340, the second interlayer dielectric layer 342 is disposed between the fourth epitaxial structure 341 and the first voltage end 600, the second through hole 343 is disposed in the second interlayer dielectric layer 342, and the fourth epitaxial structure 341 is electrically connected to the first voltage end 600 through the second through hole 343, so that the first drain 340 is electrically connected to the first voltage end 600 (as shown in FIG. 26c).

In this implementation, the third epitaxial structure 331 is disposed on the peripheral side of the first source 330, the second epitaxial structure 241 is disposed on the peripheral side of the second drain 240, the third interlayer dielectric layer 242 is disposed between the first source 330 and the third epitaxial structure 331 and between the second drain 240 and the second epitaxial structure 241, the third through hole 243 is disposed in the third interlayer dielectric layer 242, and the third epitaxial structure 331 is electrically connected to the second epitaxial structure 241 through the third through hole 243, so that the first source 330 is electrically connected to the second drain 240 (as shown in FIG. 26d). The third interlayer dielectric layer 242 and the second interlayer dielectric layer 342 may be integrally formed.

A material of the first source 330 and the first drain 340 may be SiGe, and shapes of the second source 230 and the second drain 240 are not limited to shapes in FIG. 26a. This is not limited in this application.

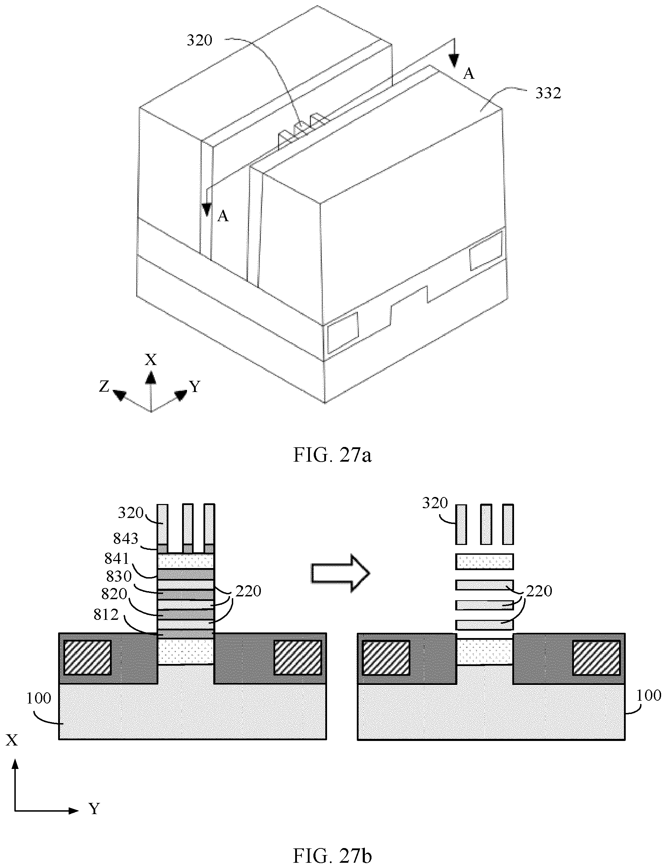

Step S12: As shown in FIG. 27a and FIG. 27b, form a fourth interlayer dielectric layer 332 on the p-type field effect transistor, remove the dummy gate 3101 to expose the first channel 320 (as shown in FIG. 27a), and remove the fifth sacrificial sub-layer 843, the third sacrificial sub-layer 841, the third sacrificial layer 830, the second sacrificial layer 820, and the second sacrificial sub-layer 812 to expose surfaces of the first channel 320 and the second channel 220 (as shown in FIG. 27b).

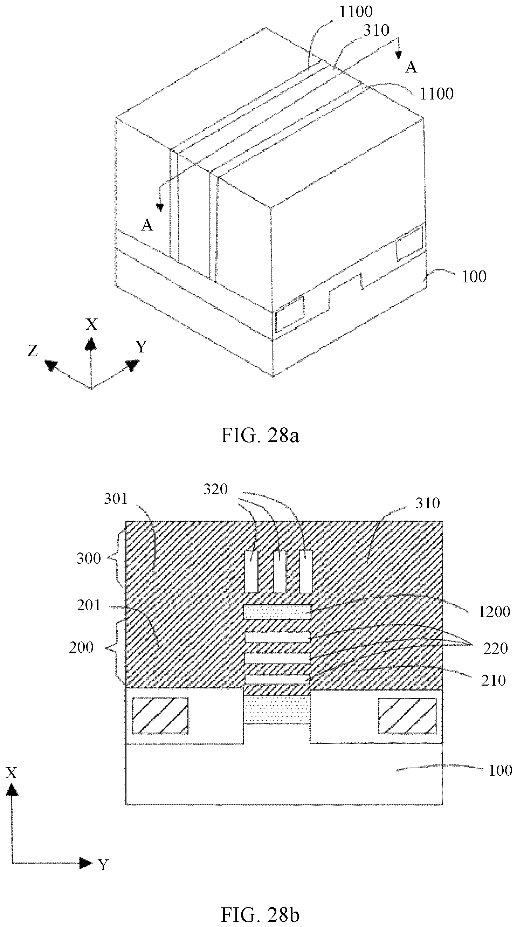

Step S13: As shown in FIG. 28a and FIG. 28b, form a first gate 310 and a second gate 210. In this step, the first gate 310 and the second gate 210 are integrally formed, and are ridge gates erected on the top surface of the substrate 100, where the ridged gate includes the first gate 310 passing through a plurality first fins 320 and the second gate 210 passing through a plurality of second fins 220, the first gate 310 and the second gate 210 are respectively located in a first region 301 and a second region 201 of the ridged gate, and the first region and the second region are isolated from each other. In other words, the first fin 320 and the second fin 220 have no cross portion in the first direction X, and the first fin 320 and the second fin 220 are separately located in their own areas. A material of the first gate 310 and the second gate 210 is a high dielectric constant conductive material, and the material of the first gate 310 and the second gate 210 may be tungsten. In this implementation, the first gate 310 surrounds the three first channels 320 and the second gate 210 surrounds the second channel 220 in a gate-all-around structure.

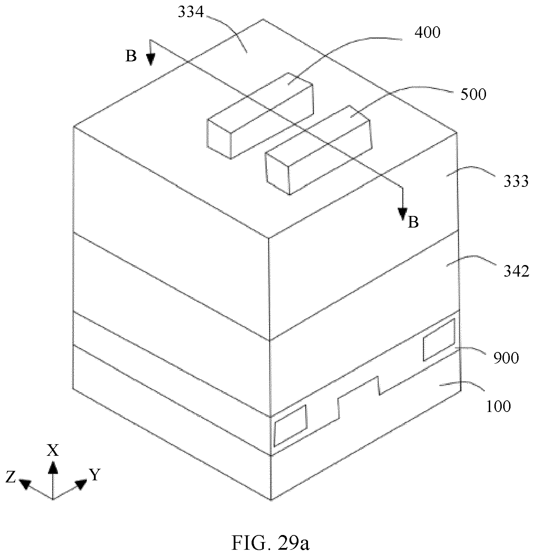

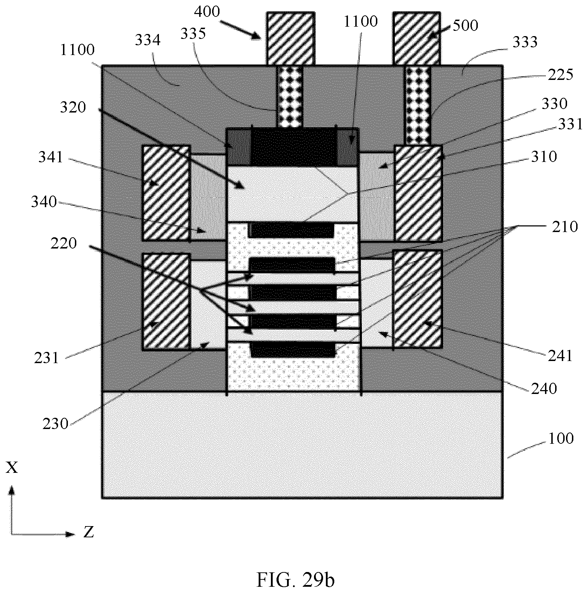

Step S14: As shown in FIG. 29a and FIG. 29b, form a fifth interlayer dielectric layer 333 and a sixth interlayer dielectric layer 334 on the p-type field effect transistor, form an output end 500 on a surface that is of the fifth interlayer dielectric layer 333 and that is away from the third epitaxial structure 331, form an input end 400 on a surface that is of the sixth interlayer dielectric layer 334 and that is away from the first gate 310, and form a fourth through hole 225 in the fifth interlayer dielectric layer 333, where the output end 500 is electrically connected to the third epitaxial structure 331 through the fourth through hole 225, so that the output end 500 is electrically connected to the first source 330. A fifth through hole 335 is formed on the sixth interlayer dielectric layer 334, and the input end 400 is electrically connected to the first gate 310 through the fifth through hole 335. In this implementation, the fifth interlayer dielectric layer 333 and the sixth interlayer dielectric layer 334 are integrally formed.

In this implementation, the inverter 10 includes the p-type field effect transistor 300 and the n-type field effect transistor 200, where the p-type field effect transistor 300 includes three first channels 320 arranged at intervals along the second direction Y, and the size of the first channel 320 in the first direction X is larger than that in the second direction Y; and the n-type field effect transistor 200 has three second channels 220 arranged at intervals along the first direction, and the size of the second channel 220 in the first direction X is smaller than that in the second direction Y

In this implementation, the p-type field effect transistor 300 further includes the first source 330 and the first drain 340, and the n-type field effect transistor 200 further includes the second source 230 and the second drain 240. The first source 330 and the first drain 340 are located at two ends of the first channel 320 along the third direction Z and are electrically connected to the first channel 320, and the second source 230 and the second drain 240 are located at two ends of the second channel 220 along the third direction Z and are electrically connected to the second channel 220, where the first source 330 and the second drain 240 are disposed on the same side, the first drain 340 and the second source 230 are disposed on the same side, and the first channel 320 and the second channel 220 extend along the third direction Z.

The output end 500 is located on a side that is of the first source 330 and that is away from the second drain 240, the fifth interlayer dielectric layer 333 is disposed between the first source 330 and the output end 500, the fourth through hole 225 is disposed in the fifth interlayer dielectric layer 333, and the first source 330 is electrically connected to the output end 500 through the fourth through hole 225; the input end 400 is located on a side that is of the first gate 310 and that is away from the second gate 210, the sixth interlayer dielectric layer 334 is disposed between the first gate 310 and the input end 400, the fifth through hole 335 is disposed in the sixth interlayer dielectric layer 334, and the first gate 310 is electrically connected to the input end 400 through the fifth through hole 335.

Materials of the first interlayer dielectric layer 232, the second interlayer dielectric layer 342, the third interlayer dielectric layer 242, the fourth interlayer dielectric layer 332, the fifth interlayer dielectric layer 333, and the sixth interlayer dielectric layer 334 are at least one of silicon oxide, silicon nitride, silicon oxynitride, silicon oxycarbide, silicon carbonitride or silicon carbonitride oxide, and low-k dielectric materials.

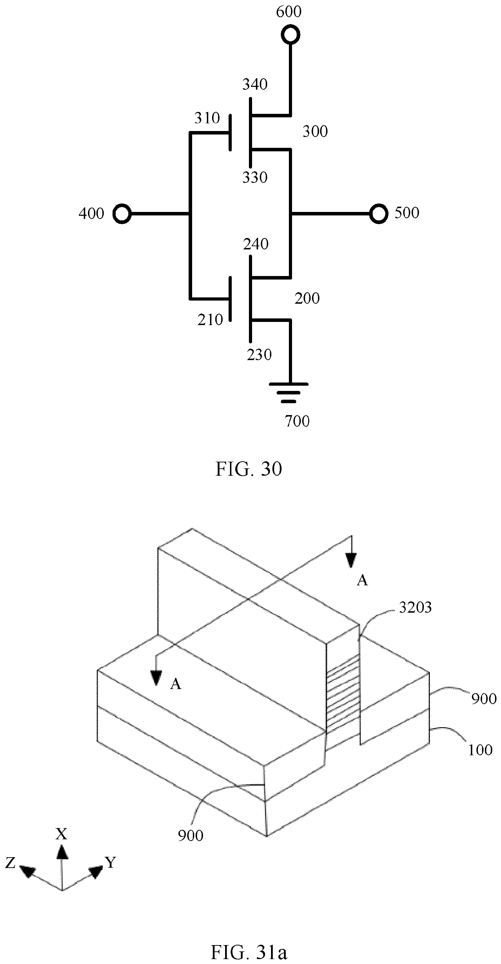

An equivalent circuit diagram of the inverter 10 in this implementation is shown in FIG. 30. The first gate 310 of the p-type field effect transistor 300 and the second gate 210 of the n-type field effect transistor 200 are electrically connected to the input end 400, the first source 330 of the p-type field effect transistor 300 and the second drain 240 of the n-type field effect transistor 200 are electrically connected to the output end 500, the first drain 340 of the p-type field effect transistor 300 is electrically connected to the first voltage end 600, and the second source 230 of the n-type field effect transistor 200 is electrically connected to the second voltage end 700. The first voltage end 600 is a high level, and the second voltage end 700 is a ground end. A working principle of the inverter 10 is as follows: When the input end 400 inputs the high level, the p-type field effect transistor 300 is disconnected, the n-type field effect transistor 200 is connected, the output end 500 is connected to the second voltage end 700, and the output end 500 outputs a low level; and when the input end 400 inputs the low level, the p-type field effect transistor 300 is connected, the n-type field effect transistor 200 is disconnected, the output end 500 is connected to the first voltage end 600, and the output end 500 outputs the high level.

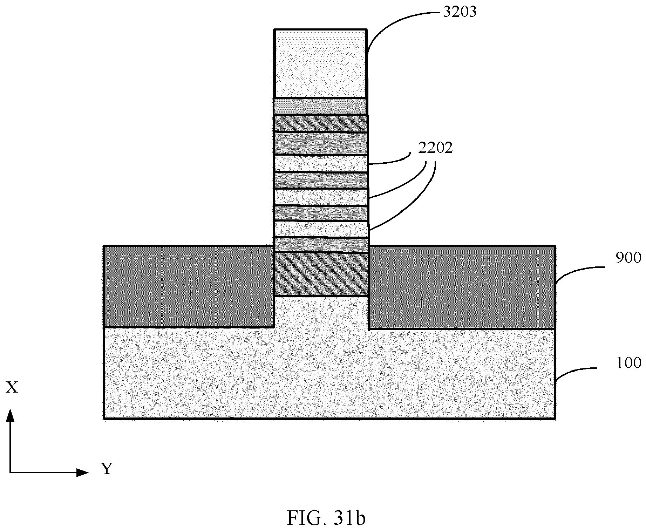

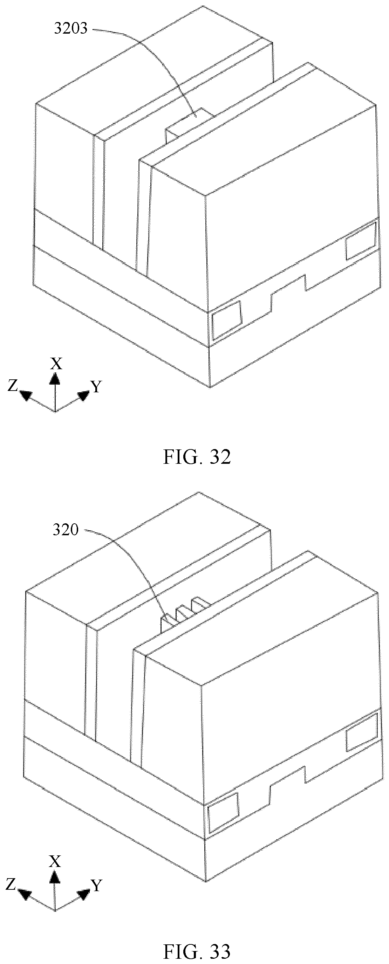

Refer to FIG. 31a and FIG. 3 1b, an implementation of this application further provides another preparation method. Different from the foregoing method, in step S2, the first channel original layer fin 3202 that has a fin shape is not first formed. Instead, the first channel original layer 3201 is etched to form a first channel original layer cube 3203, as shown in FIG. 31a and FIG. 31b. The subsequent steps are the same as those described above, until after the dummy gate 3101 (as shown in FIG. 32) is removed in step S12, three first channels 320 (as shown in FIG. 33) that are arranged at intervals along the second direction Y are formed. Other steps are the same as those in the foregoing implementation, and details are not described herein again.

Still with reference to FIG. 28a and FIG. 28b, an implementation of this application further provides a semiconductor device, including a substrate 100 and ridged gates (200, 300) erected on a top surface of the substrate 100. The semiconductor device further includes a plurality of first fins 320 passing through the gates (200, 300), and a plurality of second fins 220 passing through the gates (200, 300); the plurality of first fins 320 are parallel to each other, the first fins 320 are perpendicular to the top surface of the substrate 100, and a partial structure of the first fins 320 surrounded by the gates is p-type doped; and the plurality of second fins 220 are parallel to each other, the second fins 220 are parallel to the top surface of the substrate 100, and a partial structure of the second fins 220 surrounded by the gates is n-type doped.

In this implementation, other structures of the semiconductor device are the same as those of the inverter 10 shown in FIG. 28b, and details are not described herein again.

An implementation of this application further provides a chip, where the chip includes the inverter 10 or the semiconductor device according to any one of the foregoing implementations. The chip further includes a base board, and the inverter 10 or the semiconductor device is disposed in the base board. The chip further includes a connecting line and an electronic component, and the inverter 10 or the semiconductor device is electrically connected to the electronic component through the connecting line. Using the inverter 10 or the semiconductor device that can improve both electrical performance and miniaturization performance in this application can also improve electrical performance and miniaturization performance of the chip.

An implementation of this application further provides a terminal device, where the terminal device includes a circuit board, and the inverter 10 in any one of the foregoing implementations or the semiconductor device in the foregoing implementations is disposed on the circuit board. The terminal device includes but is not limited to a communication device, a home appliance, a computer, an unmanned aerial vehicle, and the like. For example, the terminal device is a mobile phone, and the mobile phone includes a display screen, a circuit board, a middle frame, and a rear cover, where the display screen and the rear cover are enclosed to form accommodation space, and the circuit board and the middle frame are located in the accommodation space. Using the inverter 10 or the semiconductor device that can improve both electrical performance and miniaturization performance in this application can reduce a space size of the circuit board while ensuring electrical performance of the circuit board, and can further reduce a space size of the terminal device.

The foregoing descriptions are merely specific implementations of the present invention, but are not intended to limit a protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. An inverter, wherein the inverter comprises a substrate, and an n-type field effect transistor and a p-type field effect transistor that are located on a top surface of the substrate and that are stacked along a first direction, the p-type field effect transistor comprises a first gate and a first channel, and the n-type field effect transistor comprises a second gate and a second channel;
each of the first channel and the second channel comprises a crystal plane (110) perpendicular to the top surface of the substrate and a crystal plane (100) parallel to the top surface of the substrate, wherein a size of the first channel in the first direction is larger than that in a second direction, a size of the second channel in the first direction is smaller than that in the second direction, and the size of the first channel in the first direction is larger than the size of the second channel in the first direction, wherein the first direction is perpendicular to the top surface of the substrate, and the second direction is parallel to the top surface of the substrate; and
the first channel comprises a first surface and a second surface that are disposed oppositely and that both comprise the crystal plane (110), wherein the first surface and the second surface are arranged along the second direction, and the first gate covers at least one of the first surface and the second surface; and the second channel comprises a third surface and a fourth surface that are disposed oppositely and that both comprise the crystal plane (100), wherein the third surface and the fourth surface are arranged along the first direction, and the second gate covers at least one of the third surface and the fourth surface.

2. The inverter according to claim 1, wherein the first channel further comprises a fifth surface and a sixth surface that are disposed oppositely, the fifth surface and the sixth surface are arranged along the first direction, the first surface, the fifth surface, the second surface, and the sixth surface are sequentially connected, and the first gate further covers at least one of the fifth surface and the sixth surface.

3. The inverter according to claim 1 or 2, wherein the second channel further comprises a seventh surface and an eighth surface that are disposed oppositely, the seventh surface and the eighth surface are arranged along the second direction, the third surface, the eighth surface, the fourth surface, and the seventh surface are sequentially connected, and the second gate further covers at least one of the seventh surface and the eighth surface.

4. The inverter according to any one of claims 1 to 3, wherein the n-type field effect transistor is located on a side of the substrate, and the p-type field effect transistor is located on a side that is of the n-type field effect transistor and that is away from the substrate.

5. The inverter according to any one of claims 1 to 3, wherein the p-type field effect transistor is located on a side of the substrate, and the n-type field effect transistor is located on a side that is of the p-type field effect transistor and that is away from the substrate.

6. The inverter according to any one of claims 1 to 5, wherein there are at least two first channels, and the at least two first channels are arranged and disposed at intervals along the second direction; and there are at least two second channels, and the at least two second channels are arranged at intervals along the first direction.

7. The inverter according to claim 6, wherein the p-type field effect transistor further comprises a first source and a first drain, and the n-type field effect transistor further comprises a second source and a second drain; the first source and the first drain are located at two ends of the first channel along a third direction and are electrically connected to the first channel, and the second source and the second drain are located at two ends of the second channel along the third direction and are electrically connected to the second channel; and the first source and the second drain are disposed on a same side, the first drain and the second source are disposed on a same side, and the third direction intersects the first direction and the second direction separately.

8. The inverter according to claim 7, wherein the inverter further comprises an input end, an output end, a first voltage end, and a second voltage end, the first gate and the second gate are electrically connected to the input end, the first source and the second drain are electrically connected to the output end, the first drain is electrically connected to the first voltage end, and the second source is electrically connected to the second voltage end.

9. The inverter according to claim 8, wherein a first epitaxial structure is disposed on a peripheral side of the second source, a first interlayer dielectric layer is disposed between the first epitaxial structure and the second voltage end, a first through hole is disposed in the first interlayer dielectric layer, and the first epitaxial structure is electrically connected to the second voltage end through the first through hole, so that the second source is electrically connected to the second voltage end; and
a second epitaxial structure is disposed on a peripheral side of the second drain, a third epitaxial structure is disposed on a peripheral side of the first source, a third interlayer dielectric layer is disposed between the third epitaxial structure and the second epitaxial structure, a third through hole is disposed in the third interlayer dielectric layer, and the third epitaxial structure is electrically connected to the second epitaxial structure through the third through hole, so that the first source is electrically connected to the second drain.

10. The inverter according to claim 9, wherein a fourth epitaxial structure is disposed on a peripheral side of the first drain, a second interlayer dielectric layer is disposed between the fourth epitaxial structure and the first voltage end, a second through hole is disposed in the second interlayer dielectric layer, and the fourth epitaxial structure is electrically connected to the first voltage end through the second through hole, so that the first drain is electrically connected to the first voltage end.

11. The inverter according to claim 9, wherein the output end is located on a side that is of the first source and that is away from the second drain, a fifth interlayer dielectric layer is disposed between the first source and the output end, a fourth through hole is disposed in the fifth interlayer dielectric layer, and the first source is electrically connected to the output end through the fourth through hole; and
the input end is located on a side that is of the first gate and that is away from the second gate, a sixth interlayer dielectric layer is disposed between the first gate and the input end, a fifth through hole is disposed in the sixth interlayer dielectric layer, and the first gate is electrically connected to the input end through the fifth through hole.

12. A semiconductor device, comprising a substrate and a ridged gate erected on a top surface of the substrate, wherein the semiconductor device further comprises a plurality of first fins passing through the gate and a plurality of second fins passing through the gate;
the plurality of first fins are parallel to each other, and the first fins are perpendicular to the top surface of the substrate, wherein a partial structure that is of the first fins and that is surrounded by the gate is p-type doped; and
the plurality of second fins are parallel to each other, and the second fins are parallel to the top surface of the substrate, wherein a partial structure that is of the second fins and that is surrounded by the gate is n-type doped.

13. The semiconductor device according to claim 12, wherein the plurality of first fins pass through a first region of the gate, the plurality of second fins pass through a second region of the gate, and the first region and the second region are isolated from each other.

14. The semiconductor device according to claim 13, wherein the semiconductor device further comprises a second insulation layer formed in the gate, and the second insulation layer is located between the first fin and the second fin.

15. The semiconductor device according to claim 12, wherein each of the first fin and the second fin comprises a crystal plane (110) perpendicular to the top surface of the substrate and a crystal plane (100) parallel to the top surface of the substrate; and a size of the first fin in a first direction is larger than that in a second direction, a size of the second fin in the first direction is smaller than that in the second direction, and the size of the first fin in the first direction is larger than the size of the second fin in the first direction, wherein the first direction is perpendicular to the top surface of the substrate, and the second direction is parallel to the top surface of the substrate; and
the first fin comprises a first surface and a second surface that are disposed oppositely and that both comprise the crystal plane (110), wherein the first surface and the second surface are arranged along the second direction; and the second fin comprises a third surface and a fourth surface that are disposed oppositely and that both comprise the crystal plane (100), wherein the third surface and the fourth surface are arranged along the first direction.

16. The semiconductor device according to claim 12, wherein the second fin is located on a side of the substrate, and the first fin is located on a side that is of the second fin and that is away from the substrate.

17. The semiconductor device according to claim 12, wherein the first fin is located on a side of the substrate, and the second fin is located on a side that is of the first fin and that is away from the substrate.

18. A chip, wherein the chip comprises the inverter according to any one of claims 1 to 11 or comprises the semiconductor device according to any one of claims 12 to 17.

19. A terminal device, wherein the terminal device comprises the inverter according to any one of claims 1 to 11, or comprises the semiconductor device according to any one of claims 12 to 17.

20. An inverter preparation method, wherein the inverter preparation method comprises:
forming a first channel and a second channel on a substrate, and exposing a first surface and a second surface of the first channel that are disposed oppositely and that both comprise a crystal plane (110), wherein the first surface and the second surface are arranged along a second direction; and exposing a third surface and a fourth surface of the second channel that are disposed oppositely and that both comprise a crystal plane (100), wherein the third surface and the fourth surface are arranged along a first direction, each of the first channel and the second channel comprises the crystal plane (110) perpendicular to a top surface of the substrate and the crystal plane (100) parallel to the top surface of the substrate, a size of the first channel in the first direction is larger than that in the second direction, a size of the second channel in the first direction is smaller than that in the second direction, and the size of the first channel in the first direction is larger than the size of the second channel in the first direction, wherein the first direction is perpendicular to the top surface of the substrate, and the second direction is parallel to the top surface of the substrate; and
forming a first gate on at least one of the first surface and the second surface, and forming a second gate on at least one of the third surface and the fourth surface.
